# EUROPEAN PATENT APPLICATION

(11) **EP 3 540 809 A1**
(43) Date of publication of application: **18.09.2019**
(21) Application number: 19168779.7
(22) Date of filing: 24.06.2016
(51) Int. Cl.: H01L 51/54, C07F 15/00, C09K 11/00

(54) **METAL COMPLEX AND ORGANIC LIGHT-EMITTING DEVICE**

(30) Priority: 26.06.2015 GB 201511300
(62) Divisional of application: 16732725.3
(71) Applicant: Cambridge Display Technology Limited, Cardinal Way Godmanchester Cambridgeshire PE29 2XG (GB); Sumitomo Chemical Company, Ltd., Chuo-ku Tokyo 104-8260 (JP)
(72) Inventor: TARRAN, William, Godmanchester, Cambridgeshire PE29 2XG (GB); PEGINGTON, Ruth, Godmanchester, Cambridgeshire PE29 2XG (GB); KAMTEKAR, Kiran, Godmanchester, Cambridgeshire PE29 2XG (GB); CASS, Michael, Godmanchester, Cambridgeshire PE29 2XG (GB); ROBERTS, Matthew, Godmanchester, Cambridgeshire PE29 2XG (GB)
(74) Representative: Pjanovic, Ilija

(57) **Abstract**

A metal complex of formula (I):

M(L¹)x(L²)y (I)

wherein:
M is a second or third row transition metal;
L¹ in each occurrence is independently a light-emitting ligand;
L² is an auxiliary ligand;
x is at least 1;
y is at least 1;
each L¹ is a group of formula (IIa) or (IIb): 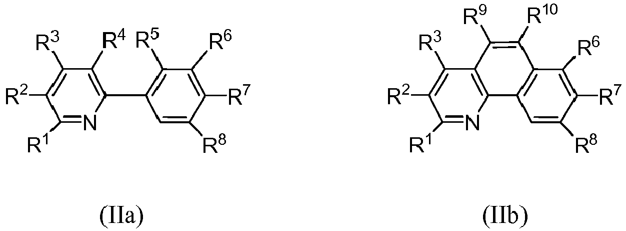 wherein R¹-R¹⁰ are each independently H or a substituent with the proviso at least one of R³, R⁵ and R⁹ of at least one L¹ is a group of formula -(Ar)ₚ wherein Ar in each occurrence is independently an aryl or heteroaryl group that may be unsubstituted or substituted with one or more substituents, and p is at least 2.

## Description

### BACKGROUND

Electronic devices containing active organic materials are attracting increasing attention for use in devices such as organic light emitting diodes (OLEDs), organic photoresponsive devices (in particular organic photovoltaic devices and organic photosensors), organic transistors and memory array devices. Devices containing active organic materials offer benefits such as low weight, low power consumption and flexibility. Moreover, use of soluble organic materials allows use of solution processing in device manufacture, for example inkjet printing or spin-coating.

An OLED comprises an anode, a cathode and one or more organic light-emitting layers between the anode and cathode. Non-emissive layers, for example charge transporting layers, may be provided between the anode and cathode.

Holes are injected into the device through the anode and electrons are injected through the cathode during operation of the device. Holes in the highest occupied molecular orbital (HOMO) and electrons in the lowest unoccupied molecular orbital (LUMO) of a light-emitting material combine to form an exciton that releases its energy as light.

Light-emitting materials include small molecule, polymeric and dendrimeric materials. Fluorescent light-emitting polymers include poly(arylene vinylenes) such as poly(p-phenylene vinylenes) and polyarylenes such as polyfluorenes.

A light-emitting dopant, for example a fluorescent or phosphorescent dopant, may be used with a charge-transporting host material.

A significant proportion of light generated within an OLED may reflect or be absorbed within the device, limiting the external quantum efficiency of the device.

Kim et al, Adv. Mater. 26(23), 3844-3847, 2014 "Highly Efficient Organic Light-Emitting Diodes with Phosphorescent Emitters Having High Quantum Yield and Horizontal Orientation of Transition Dipole Moments" discloses a heteroleptic iridium complex having a preferred dipole orientation in the horizontal direction. US8809841 disclose a device wherein a transition dipole moment of a luminescent center material is parallel to a top surface of a substrate, and wherein a transition dipole moment of a host material is parallel to the top surface of the substrate.

Kozhevnikov et al, Chem. Mater., 2013, 25 (11), pp 2352-2358 discloses compounds 1 and 5 of formulae:

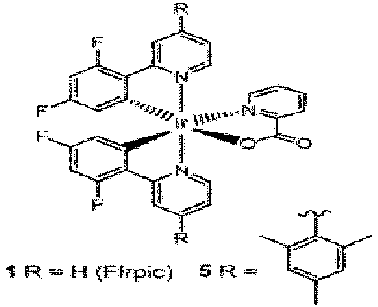

It is an object of the invention to improve the efficiency of organic light-emitting devices.

### SUMMARY OF THE INVENTION

In a first aspect the invention provides a metal complex of formula (I):

M(L¹)x(L²)y (I)

wherein:
M is a second or third row transition metal;
L¹ in each occurrence is independently a light-emitting ligand;
L² is an auxiliary ligand;
x is at least 1;
y is at least 1; and
each L¹ is a group of formula (IIa) or (IIb): 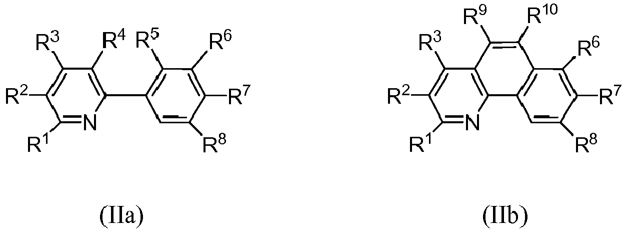
wherein R¹-R¹⁰ are each independently H or a substituent with the proviso at least one of R³, R⁵ and R⁹ of at least one L¹ is a group of formula -(Ar)ₚ wherein Ar in each occurrence is independently an aryl or heteroaryl group that may be unsubstituted or substituted with one or more substituents, and p is at least 2.

In a second aspect the invention provides a metal complex of formula (I):

M(L¹)x(L²)y (I)

wherein:
M is a second or third row transition metal;
L¹ in each occurrence is independently a light-emitting ligand;
L² is an auxiliary ligand;
x is at least 1;
y is at least 1;
at least one L¹ is substituted with at least one group of formula -(Ar)ₚ wherein Ar in each occurrence is independently an aryl or heteroaryl group that may be unsubstituted or substituted with one or more substituents, and p is at least 2; and
an angle between a transition dipole moment vector of the metal complex and a bond vector of at least one L¹-(Ar)ₚ bond is less than 15°.

In a third aspect the invention provides a metal complex of formula (I):

M(L¹)x(L²)y (I)

wherein:
M is a second or third row transition metal;
L¹ in each occurrence is independently a light-emitting ligand;
L² is an auxiliary ligand;
x is at least 1;
y is at least 1;
at least one L¹ is substituted with at least one group of formula -(Ar)ₚ wherein Ar in each occurrence is independently an aryl or heteroaryl group that may be unsubstituted or substituted with one or more substituents, and p is at least 2, such that an a : b ratio of the metal complex is at least 3 : 1 wherein a is a dimension of the complex in a direction parallel to a transition dipole moment of the complex and b is a dimension of the complex in any direction perpendicular to the transition dipole moment of the complex.

In a fourth aspect the invention provides a composition comprising a metal complex according to the first, second or third aspect and a host.

In a fifth aspect the invention provides a formulation comprising a composition according to the fourth aspect and at least one solvent.

In a sixth aspect the invention provides an organic light-emitting device comprising an anode, a cathode and a light-emitting layer between the anode and cathode comprising a composition according to the fifth aspect.

In a seventh aspect the invention provides method of forming a device according to the sixth aspect, the method comprising the step of depositing the formulation of the fifth aspect over one of the anode and cathode and evaporating the at least one solvent to form the light-emitting layer, and forming the other of the anode and cathode over the light-emitting layer.

In an eighth aspect the invention provides a light-emitting polymer comprising a light-emitting repeat unit of formula (XIIIa) or (XIIIb): 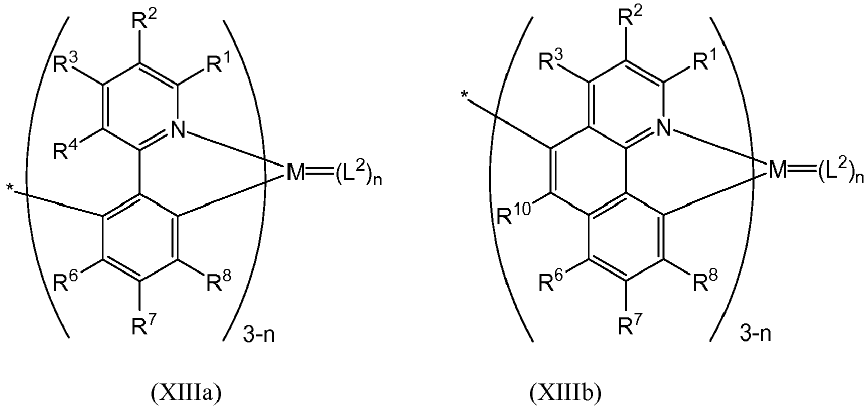 wherein M is a metal, preferably a transition metal; wherein R^{1,} R², R³, R⁴, R⁶, R⁷, R⁸ and R¹⁰ are each independently H or a substituent; L² is a ligand as described with reference to the complex of formula (I); and n is 1 or 2. L² is different from the ligand of formula (XIIIa) or (XIIIb). Preferably n is 1.

Preferably M is as described with reference to the complex of formula (I). Iridium (III) is particularly preferred.

Preferably R^{1,} R², R³, R⁴, R⁶, R⁷, R⁸, and R¹⁰ are each independently as described with reference to the ligands of formula (IIa) or (IIb).

The repeat units of formula (XIIIa) or (XIIIb) may be bound directly to an adjacent co-repeat unit or may be spaced apart therefrom, optionally spaced apart by a group of formula (Ar⁴)_{z}, as described with reference to formulae (XIIIa-m) and (XIIIb-m).

In a ninth aspect the invention provides an organic light-emitting device comprising an anode, a cathode and a light-emitting layer between the anode and the cathode wherein the light-emitting layer comprises a polymer according to the eighth aspect.

In a tenth aspect the invention provides a monomer of formula (XIIIa-m) or (XIIIb-m): 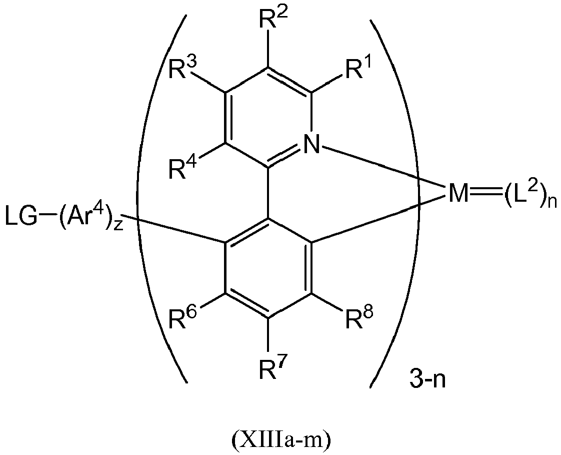 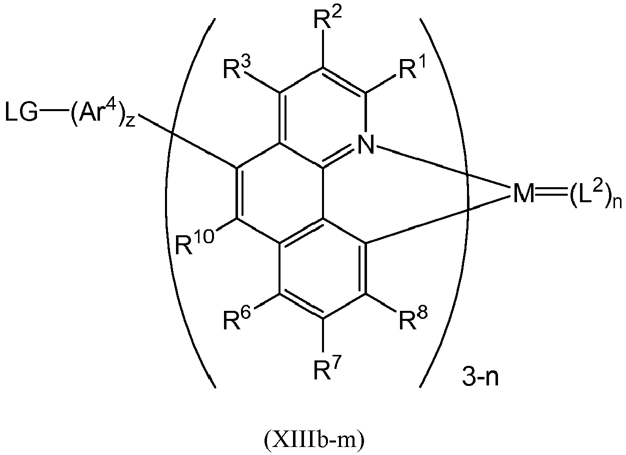 wherein M, R^{1,} R², R³, R⁴, R⁶, R⁷, R⁸ and R¹⁰, n and L² are as described with reference to repeat units of formulae (XIIIa) and (XIIIb); LG is a leaving group; Ar⁴ is an aryl or heteroaryl group; and z is 0, 1, 2 or 3.

Preferably, LG in each occurrence is selected from halogen; boronic acid and esters thereof; and sulfonic acid and esters thereof, more preferably bromine, iodine, boronic acid or boronic ester.

Ar⁴ is preferably a 1,4-linked phenylene which may be unsubstituted or substituted with one or more substituents, optionally one or more C₁₋₁₂ alkyl groups wherein one or more non-adjacent C atoms may be replaced with O, S, CO or COO. z is preferably 0 or 1. Two or more substituents of Ar⁴ may be linked to form, with Ar⁴, a fused aromatic group which may be unsubstituted or substituted with one or more substituents, optionally one or more C₁₋₁₂ alkyl groups wherein one or more non-adjacent C atoms may be replaced with O, S, CO or COO.

In an eleventh aspect the invention provides a method of forming a polymer, the method comprising the step of polymerizing a monomer according to the tenth aspect. Preferably, the monomer according to the tenth aspect is copolymerized with one or more co-monomers for forming one or more co-repeat units.

### DESCRIPTION OF THE DRAWINGS

The invention will now be described in more detail with reference to the Drawings in which:
Figure 1 is a schematic illustration of an OLED according to an embodiment of the invention;
Figure 2 illustrates a compound according to an embodiment of the invention;
Figure 3 illustrates a further compound according to an embodiment of the invention;
   and
Figure 4 is a graph of external quantum efficiencies of a device according to an embodiment of the invention and a comparative device.

### DETAILED DESCRIPTION OF THE INVENTION

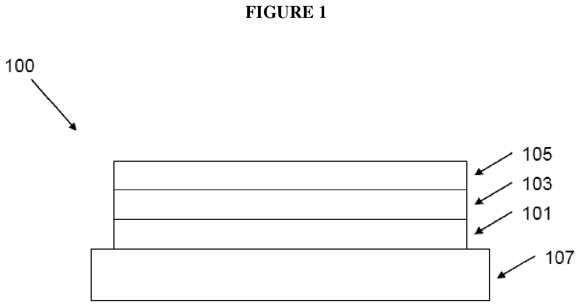

With reference to Figure 1, an OLED 100 according to an embodiment of the invention has an anode 101, a cathode 105 and a light-emitting layer 103 between the anode and the cathode. The device is supported on a substrate 107, which may be a glass or plastic substrate.

One or more further layers may be provided between the anode and the cathode. Optionally, further layers may be selected from one or more of a hole-injection layer, a hole-transporting layer, an electron-blocking layer, a electron-transporting layer and an electron blocking layer.

Exemplary OLED layer structures include the following:
Anode / Light-emitting layer / Cathode
Anode / Hole transporting layer / Light-emitting layer / Cathode
Anode / Hole-injection layer / Hole-transporting layer / Light-emitting layer / Cathode
Anode / Hole-injection layer / Hole-transporting layer / Light-emitting layer / Electron-transporting layer / Cathode.

Preferably, a hole-injection layer is present between the anode and the light-emitting layer.

Preferably, a hole-transporting layer is present between the anode and the light-emitting layer.

Preferably, both of a hole-injection layer and a hole-transporting layer are present.

In one embodiment, substantially all light is emitted from light-emitting layer 103. In other embodiments, one or more further layers may emit light in addition to light-emitting layer 103. Optionally, one of a hole-transporting layer and an electron-transporting layer comprises a light-emitting material and emits light in use.

The light-emitting layer 103 contains a host material and a heteroleptic phosphorescent metal complex wherein the or each substituent X of the ligands of the metal complex are selected such that at least one substituent X is aligned with the S₁ transition dipole moment of the metal complex. The light-emitting layer 103 may consist of the host material and metal complex or may comprise one or more further materials, optionally one or more further light-emitting materials.

By "heteroleptic" as used herein is meant that the ligands of the phosphorescent metal complex include at least two ligands having different coordinating groups.

By "aligned with the S₁ transition dipole moment" as used herein is meant that at least one substituent X is substituted on a ligand such that an angle between the S¹ transition dipole moment vector and the ligand-X bond is no more than 15°, optionally no more than 10°, optionally no more than 5°, optionally 0.

By "light-emitting ligand" as used herein is meant a ligand having molecular orbitals that contribute to the lowest singlet excited state (S₁) of the metal complex, for example by MLCT.

By "auxiliary ligand" as used herein is meant a ligand having molecular orbitals that do not contribute to the lowest singlet excited state (S₁) of the metal complex, for example by MLCT.

The heteroleptic phosphorescent metal complex may be, without limitation, a red, green or blue light-emitting material.

A blue light emitting material may have a photoluminescent spectrum with a peak in the range of 400-490 nm.

A green light emitting material may have a photoluminescent spectrum with a peak in the range of more than 490 nm up to 580 nm.

A red light emitting material may optionally have a peak in its photoluminescent spectrum of more than 580 nm up to 650 nm, preferably 600-630 nm.

The photoluminescence spectrum of a light-emitting material may be measured by casting 5 wt % of the material in a PMMA film onto a quartz substrate to achieve transmittance values of 0.3-0.4 and measuring in a nitrogen environment using apparatus C9920-02 supplied by Hamamatsu.

The metal complex of formula (I) may be provided with one or more further light-emitting materials that in combination produce white light when the OLED is in use. The white-emitting OLED may have CIE x coordinate equivalent to that emitted by a black body at a temperature in the range of 2500-9000K and a CIE y coordinate within 0.05 or 0.025 of the CIE y co-ordinate of said light emitted by a black body, optionally a CIE x coordinate equivalent to that emitted by a black body at a temperature in the range of 2700-6000K.

Further light-emitting materials may be provided in light-emitting layer 103 and / or in another layer or other layers of the device. Further light-emitting materials may be fluorescent or phosphorescent.

The present inventors have found that an OLED having a high external quantum efficiency can be obtained by using phosphorescent metal complexes as described herein a light-emitting materials of the device. Without wishing to be bound by any theory, it is believed that providing substituents X that are aligned with the S₁ transition dipole moment causes the S₁ transition dipole moment of the metal complex to align with the plane of the surface that the phosphorescent metal complex is deposited onto. Preferably, the light-emitting layer is a film having an anisotropy factor α of less than 0.85, preferably less than 0.50 or 0.40.

Preferably, the complex of formula (I) has an octahedral geometry.

The compound of formula A illustrates a metal complex according to an embodiment of the invention:

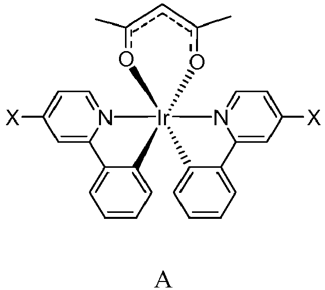

The S₁ transition dipole moment, as determined by quantum chemical modelling as described herein, extends parallel to the Ir-N bonds of formula (A). The ligand-X bond of formula A and the transition dipole moment are substantially parallel. The same applies to complexes (B) and (C) illustrated below:

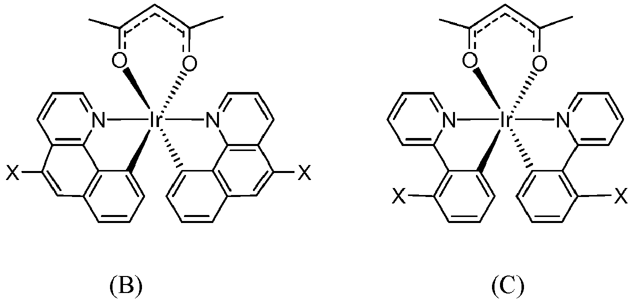

At least one substituent X is aligned with the transition dipole moment.

In the case where x of formula (I) is 2, the metal-N bonds are preferably parallel. With reference to Formulae A, B and C, replacing the acac ligand with a further phenylpyridine ligand will produce a complex having an Ir-N bond that is not parallel to the other Ir-N bonds of the complex.

M of formula (I) may be selected from rows 2 and 3 d block elements, and preferably from ruthenium, rhodium, palladium, rhenium, osmium, iridium, platinum and gold. Iridium is particularly preferred.

Optionally, the or each L¹ of the compound of formula (I) is selected from ligands of formulae (IIa) or (IIb): 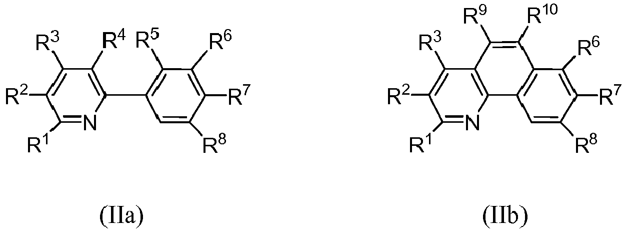 wherein:
R¹-R¹⁰ are each independently selected from H, a substituent X or a substituent other than X; and
and
   (a) the metal complex has formula ML¹(L²)₂ and one, two or more of R³, R⁵ and R⁹ is a substituent X; or
   (b) the metal complex has formula M(L¹)₂L² wherein one, two or more of R³, R⁵ and R⁹ of one L¹ is a substituent X, and one or more of R¹-R¹⁰ of the other L¹ is a substituent X..

Preferably, the compound has formula M(L¹)₂L² and only R³ is a group of formula X.

If more than one ligand L¹ is present then the substitution of groups X may be the same or different on different ligands L¹.

Preferably, each ligand L¹ is the same for ease of synthesis.

Groups R¹-R¹⁰ that are not a substituent X are preferably selected from H, D, F and C₁₋₁₀ alkyl wherein one or more non-adjacent C atoms may be replaced by O, S, C=O or COO and one or more H atoms may be replaced by F. Two or more adjacent groups R¹-R¹⁰ that are not alkyl may be linked to form an aromatic or non-aromatic ring, optionally phenyl, that may be unsubstituted or substituted with one or more substituents, optionally one or more C₁₋₂₀ alkyl groups. More preferably, groups R¹-R¹⁰ that are not a substituent X are H.

Preferably, the complex of formula (I) has an aspect ratio a : b of at least 3 : 1 wherein a is a dimension of the complex in a direction parallel to a transition dipole moment of the complex and b is a dimension of the complex in any direction perpendicular to the transition dipole moment of the complex. Optionally, the a : b ratio is at least 4 : 1 or at least 5 : 1. The substituent X has formula -(Ar)ₚ wherein p is at least 2, optionally 3, and each Ar is independently an unsubstituted or substituted aryl or heteroaryl group. Dimensions may be determined by molecular modelling as described herein.

p can be 1-10 provided that substituent X has higher T¹ than the emitter core.

Preferably, each Ar is independently selected from a C₆₋₂₀ aryl group, optionally phenyl, or a 6-membered heteroaryl of C and N atoms, optionally triazine.

Each Ar is independently unsubstituted or substituted with one or more substituents. Exemplary substituents are C₁₋₂₀ alkyl wherein one or more non-adjacent C atoms may be replaced by O, S, C=O or COO and one or more H atoms may be replaced with F.

Optionally, a position of the Ar group adjacent to a bond between L¹ and X is substituted with such a substituent to create a twist between L¹ and X.

Optionally, at least one Ar group is substituted with a C₁₋₂₀ alkyl group to enhance solubility of the compound of formula (I) in solvents as described herein.

The group of formula -(Ar)ₚ may be a linear or branched chain of Ar groups. A branched chain of -(Ar)ₚ groups may form a dendron.

A dendron may have optionally substituted formula (III) 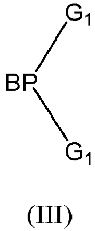 wherein BP represents a branching point for attachment to a core and G₁ represents first generation branching groups.

The dendron may be a first, second, third or higher generation dendron. G₁ may be substituted with two or more second generation branching groups G₂, and so on, as in optionally substituted formula (IIIa): 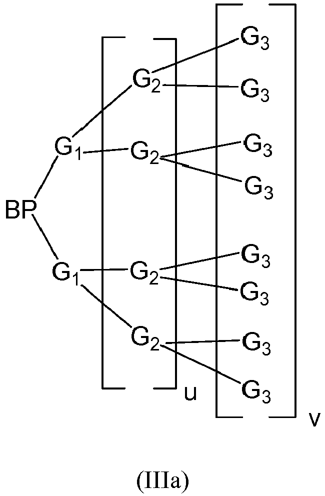 wherein u is 0 or 1; v is 0 if u is 0 or may be 0 or 1 if u is 1; BP represents a branching point for attachment to a core and G₁, G₂ and G₃ represent first, second and third generation dendron branching groups. In one preferred embodiment, each of BP and G₁, G₂ ... Gₙ is phenyl, and each phenyl BP, G₁, G₂ ... Gₙ₋₁ is a 3,5-linked phenyl.

Exemplary groups X include the following, each of which may be unsubstituted or substituted with one or more substituents: 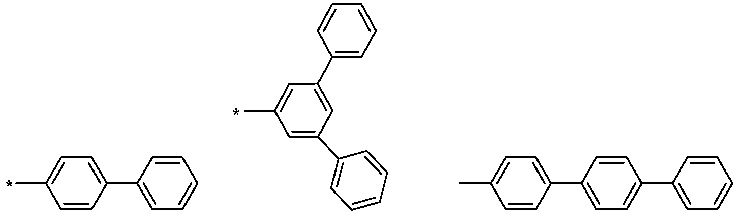 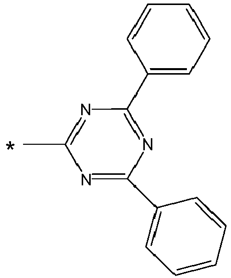 wherein * is a point of attachment to L¹.

Exemplary ligands L² are:
N,N-chelating ligands, optionally pyridine carboxamides; pyridyl pyrazolates; pyridyl triazolates; amidates;
N,O--chelating ligands, optionally picolinate or iminophenol; and
O,O--chelating ligands, optionally diketonates; or acetates.

Exemplary diketonates have formula: 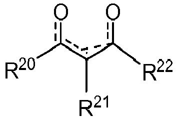 wherein R²⁰ and R²² are each independently a substituent; R²¹ is H or a substituent; and wherein R²⁰ and R²¹ or R²¹ and R²² may be linked to form a ring. Preferably, R²⁰, and R²² are each independently a C₁₋₁₀ alkyl group. Preferably, R²¹ is H or a C₁₋₁₀ alkyl group. R²⁰ and R²¹ may be linked to form a 6-10 membered aromatic or heteroaromatic ring that may be unsubstituted or substituted with one or more substituents, optionally one or more substituents selected from C₁₋₂₀ hydrocarbyl groups.

Exemplary diketonates are acac and:

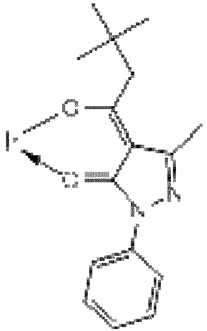

N,O-chelating ligands include a ligand of formula (V): 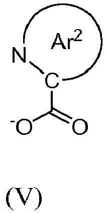 wherein Ar² is a heteroaryl, preferably a 5-10 membered heteroaryl of C and N atoms that may be unsubstituted or substituted with one or more substituents, optionally one or more C₁₋₁₀ alkyl groups.

Exemplary N,N-chelating ligands have formula (IV): 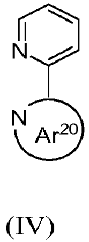 wherein Ar²⁰ independently in each occurrence is a 5-10 membered heteroaryl group, optionally a 5-membered heteroaryl containing N and C atoms, optionally pyrazole or triazole.

Ligands of formula (IV) may be unsubstituted or may be substituted with one or more substituents. Exemplary substituents are C₆₋₁₀ aryl or 5-10 membered heteroaryl groups, optionally phenyl that may be unsubstituted or substituted with one or more substituents, and C₁₋₁₀ alkyl wherein one or more non-adjacent C atoms may be replaced with O, S, C=O or COO H atoms may be replaced with F.

Exemplary ligands of formula (IV) are:

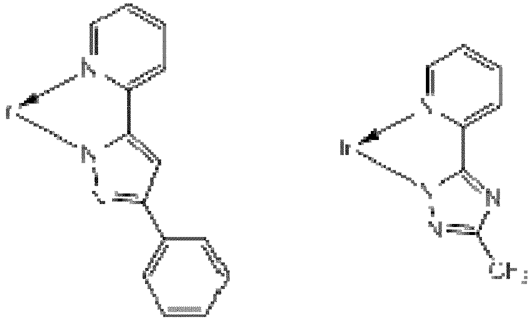

The S¹ transition dipole moment vector of a compound of formula (I) may be determined by quantum chemical modelling using Gaussian09 software available from Gaussian, Inc. according to the following steps:
(i) Optimise the ground state geometry of the molecule using a DFT calculation in using B3LYP/6-31g(d).
(ii) Using this geometry, use time dependent density functional theory to calculate the excited states of the molecule. The S₁ transition dipole moment is calculated along with the energy for singlet excited states, and the transition dipole moment of the lowest triplet excited state is taken to match that of the lowest singlet excited state. "lanl2dz" is used for phosphorescent light-emitting repeat units, in particular iridium light-emitting repeat units.

Bond lengths and bond vectors may be determined from this model.

### Host

The host used with the metal complex of formula (I) may be a small molecule, dendrimeric or polymeric material. Preferably the host is a polymer.

The value of the anisotropy factor α of a film of a composition of a metal complex of formula (I) and a host may be affected by the structure of the host.

Preferably, the host material has an α absorption value measured as described herein of 0.85, preferably less than 0.50 or 0.40.

A polymeric host may have a rod-like backbone.

Optionally, the host polymer is a conjugated polymer comprising arylene or heteroarylene repeat units.

The polymer may comprise co-repeat units of formula (VI): 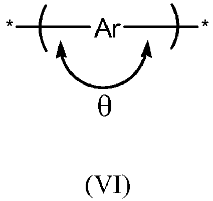 wherein Ar is an arylene or heteroarylene group, more preferably a C₆₋₂₀ aryl group, that may be unsubstituted or substituted with one or more substituents, and angle θ is 140°-180°

Exemplary arylene repeat units of formula (VI) include, without limitation, 1,4-linked phenylene repeat units; 2,7-linked fluorene repeat units; 2-8-linked phenanthrene repeat units; 2,8-linked dihydrophenanthrene repeat units; and 2,7-linked triphenylene repeat units, each of which may be unsubstituted or substituted with one or more substituents.

Optionally, angle θ is 160°-180°, optionally 170°-180° Optionally, 1-100 mol %, optionally 10-95 mol % or 20-80 mol % of repeat units of the polymer may be repeat units of formula (VI).

The 1,4-phenylene repeat unit may have formula (VII) 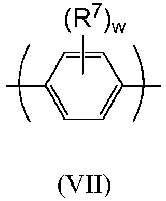 wherein w in each occurrence is independently 0, 1, 2, 3 or 4, optionally 1 or 2; and R⁷ independently in each occurrence is a substituent.

Where present, each R⁷ may independently be selected from the group consisting of:
alkyl, optionally C₁₋₂₀ alkyl, wherein one or more non-adjacent C atoms may be replaced with optionally substituted aryl or heteroaryl, O, S, substituted N, C=O or - COO-, and one or more H atoms may be replaced with F;
aryl and heteroaryl groups that may be unsubstituted or substituted with one or more substituents, preferably phenyl substituted with one or more C₁₋₂₀ alkyl groups; and
-(Ar¹)_{c} wherein each Ar¹ is independently an aryl or heteroaryl group that may be unsubstituted or substituted with one or more substituents and c is at least 1, optionally 1 2 or 3
Ar¹ in each occurrence is preferably a C₆₋₂₀ aryl group, more preferably phenyl. The group -(Ar¹)_{c} may form a linear or branched chain of aryl or heteroaryl groups in the case where c is at least 2. Preferred substituents of Ar¹ are C₁₋₂₀ alkyl groups.

Substituted N, where present, may be -NR²- wherein R² is C₁₋₂₀ alkyl; unsubstituted phenyl; or phenyl substituted with one or more C₁₋₂₀ alkyl groups.

Preferably, each R⁷ is independently selected from C₁₋₄₀ hydrocarbyl, and is more preferably selected from C₁₋₂₀ alkyl; unusubstituted phenyl; and phenyl substituted with one or more C₁₋₂₀ alkyl groups; and a linear or branched chain of phenyl groups, wherein each phenyl may be unsubstituted or substituted with one or more substituents.

Substituents R⁷ of formula (VII), if present, are adjacent to linking positions of the repeat unit, which may cause steric hindrance between the repeat unit of formula (VII) and adjacent repeat units, resulting in the repeat unit of formula (VII) twisting out of plane relative to one or both adjacent repeat units.

A particularly preferred repeat unit of formula (VII) has formula (VIIa):

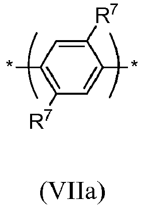

A 2,7-linked fluorene repeat unit may have formula (IX): 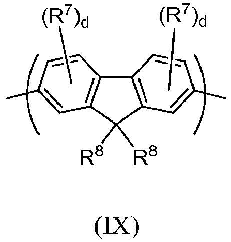 wherein R⁸ in each occurrence is the same or different and is a substituent wherein the two groups R⁸ may be linked to form a ring; R⁷ is a substituent as described above; and d is 0, 1, 2 or 3.

Each R⁸ may independently be selected from the group consisting of:
- alkyl, optionally C₁₋₂₀ alkyl, wherein one or more non-adjacent C atoms may be replaced with optionally substituted aryl or heteroaryl, O, S, substituted N, C=O or - COO-, and one or more H atoms may be replaced with F;
- aryl and heteroaryl groups that may be unsubstituted or substituted with one or more substituents, preferably phenyl substituted with one or more C₁₋₂₀ alkyl groups; and
- a linear or branched chain of aryl or heteroaryl groups, each of which groups may independently be substituted, for example a group of formula -(Ar⁷)_{d} wherein each Ar⁷ is independently an aryl or heteroaryl group and d is at least 2, optionally 2 or 3, preferably a branched or linear chain of phenyl groups each of which may be unsubstituted or substituted with one or more C₁₋₂₀ alkyl groups.

Preferably, each R⁸ is independently a C₁₋₄₀ hydrocarbyl group.

Different groups R⁸ are disclosed in WO 2012/104579 the contents of which are incorporated in entirety by reference.

Substituted N, where present, may be -NR²- wherein R² is as described above.

Exemplary substituents R⁷ are alkyl, for example C₁₋₂₀ alkyl, wherein one or more non-adjacent C atoms may be replaced with O, S, C=O and -COO-, optionally substituted aryl, optionally substituted heteroaryl, fluorine, cyano and arylalkyl. Particularly preferred substituents include C₁₋₂₀ alkyl and substituted or unsubstituted aryl, for example phenyl. Optional substituents for the aryl include one or more C₁₋₂₀ alkyl groups.

The extent of conjugation of repeat units of formula (IX) to aryl or heteroaryl groups of adjacent repeat units in the polymer backbone may be controlled by substituting the repeat unit with one or more substituents R⁸ in or more positions adjacent to the linking positions in order to create a twist with the adjacent repeat unit or units, for example a 2,7-linked fluorene carrying a C₁₋₂₀ alkyl substituent in one or both of the 3- and 6-positions.

The repeat unit of formula (VI) may have formula (X) or (XI): 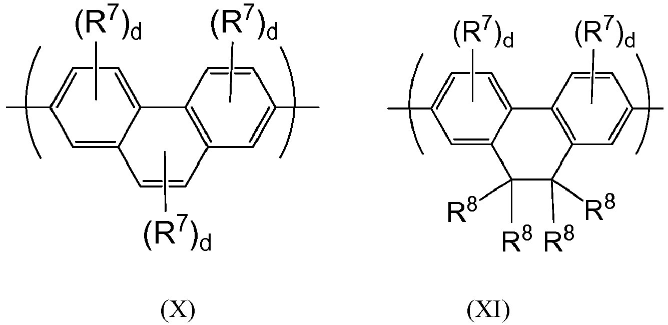 wherein R⁷, R⁸ and d are as described with reference to formulae (VII) and (IX) above.

Any of the R⁷ groups of formulae (X) and (XI) may be linked to any other of the R⁷ groups to form a ring. The ring so formed may be unsubstituted or may be substituted with one or more substituents, optionally one or more C₁₋₂₀ alkyl groups.

Any of the R⁸ groups of formula (XI) may be linked to any other of the R⁸ groups to form a ring. The ring so formed may be unsubstituted or may be substituted with one or more substituents, optionally one or more C₁₋₂₀ alkyl groups.

The host polymer may contain repeat units of formula (X): 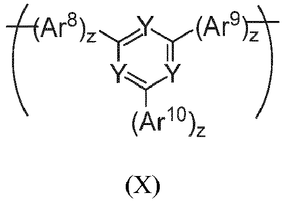 wherein Ar⁸, Ar⁹ and Ar¹⁰ are each independently unsubstituted or substituted with one or more, optionally 1, 2, 3 or 4, substituents, z in each occurrence is independently at least 1, optionally 1, 2 or 3, preferably 1, and Y is N or CR¹⁴, wherein R¹⁴ is H or a substituent, preferably H or C₁₋₁₀ alkyl and with the proviso that at least one Y is N. Preferably, Ar⁸, Ar⁹ and Ar¹⁰ of formula (X) are each phenyl, each phenyl being optionally and independently substituted with one or more C₁₋₂₀ alkyl groups.

Substituents of Ar⁸, Ar⁹ and Ar¹⁰ may be selected from substituted or unsubstituted alkyl, optionally C₁₋₂₀ alkyl, wherein one or more non-adjacent C atoms may be replaced with optionally substituted aryl or heteroaryl (preferably phenyl), O, S, C=O or -COO- and one or more H atoms may be replaced with F.

Preferred substituents of Ar⁸, Ar⁹ and Ar¹⁰, if present, are C₁₋₄₀ hydrocarbyl, preferably C₁₋₂₀ alkyl or a hydrocarbyl crosslinking group.

In one preferred embodiment, all 3 groups Y are N.

Ar¹⁰ of formula (X) is preferably phenyl, and is optionally substituted with one or more C₁₋₂₀ alkyl groups or a crosslinkable unit. The crosslinkable unit may be bound directly to Ar¹⁰ or spaced apart from Ar¹⁰ by a spacer group.

Preferably, z is 1 and each of Ar⁸, Ar⁹ and Ar¹⁰ is unsubstituted phenyl or phenyl substituted with one or more C₁₋₂₀ alkyl groups.

A particularly preferred repeat unit of formula (X) has formula (Xa), which may be unsubstituted or substituted with or or more substituents R⁵, preferably one or more C₁₋₂₀ alkyl groups:

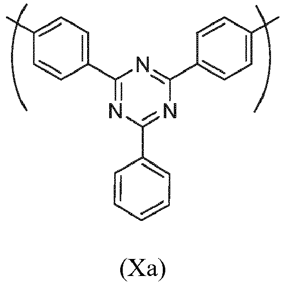

The metal complex of formula (I) may be provided in an amount in the range of 0.1-40 wt % in a composition comprising the host and the metal complex of formula (I).

The lowest triplet excited state energy level of the host material is at least the same as or higher than that of the metal complex. Triplet energy levels may be measured from the energy onset of the phosphorescence spectrum measured by low temperature phosphorescence spectroscopy (Y.V. Romaovskii et al, Physical Review Letters, 2000, 85 (5), p1027, A. van Dijken et al, Journal of the American Chemical Society, 2004, 126, p7718).

The metal complex may be admixed with the host or may be covalently bound to the host. In the case of a host polymer the metal complex may be provided as a side-group or end group of the polymer backbone or as a repeat unit in the backbone of the polymer.

### Light emitting polymer

The light-emitting polymer comprising a light-emitting repeat unit of formula (XIIIa) or (XIIIb) preferably has an anisotropy factor α of no more than 0.8, preferably no more than 0.7, more preferably no more than 0.5. The value of the anisotropy factor α may be affected by the structure and / or molar percentage of the light-emitting repeat unit and / or co-repeat units. Co-repeat units may be selected to give, in combination with an aligned light-emitting repeat unit, a required anisotropy factor α of the polymer.

Suitable co-repeat units include electron-transporting co-repeat units; hole-transporting co-repeat units; and light-emitting co-repeat units wherein the transition dipole moment of the light-emitting co-repeat unit is not aligned with the polymer backbone.

The co-repeat units may form a rod-like backbone.

Preferably, the light-emitting polymer may comprise co-repeat units of formula (VI). Co-repeat units of formula (VI) are as described above in relation to a host.

The light-emitting polymer comprising a light-emitting repeat unit of formula (XIIIa) or (XIIIb) optionally has a polystyrene-equivalent number-average molecular weight (Mn) measured by gel permeation chromatography in the range of about 1x10³ to 1x10⁸, and preferably 1x10³ to 5x10⁶. The polystyrene-equivalent weight-average molecular weight (Mw) of the polymers described herein may be 1x10³ to 1x10⁸, and preferably 1x10⁴ to 1x10⁷.

### Polymerisation method

Conjugated polymers as described herein may be formed by metal catalysed polymerisations such as Yamamoto polymerisation and Suzuki polymerisation as disclosed in WO 00/53656, WO 03/091355 and EP1245659, the contents of which are incorporated herein by reference.

Preferably, the polymer is formed by polymerising monomers comprising leaving groups that leave upon polymerisation of the monomers. Preferably, the polymer is formed by polymerising monomers comprising boronic acid and ester groups bound to aromatic carbon atoms of the monomer with monomers comprising leaving groups selected from halogen, sulfonic acid or sulfonic ester, preferably bromine or iodine, bound to aromatic carbon atoms of the monomer in the presence of a palladium (0) or palladium (II) catalyst and a base.

Exemplary boronic esters have formula (XII): 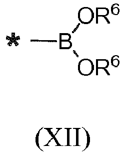 wherein R⁶ in each occurrence is independently a C₁₋₂₀ alkyl group, * represents the point of attachment of the boronic ester to an aromatic ring of the monomer, and the two groups R⁶ may be linked to form a ring.

### Solution processing

A light-emitting layer as described herein may be formed by depositing a solution of the compound of formula (I), the host and, if present, any other components of the light-emitting layer dissolved in a solvent or solvent mixture.

Exemplary solvents are benzenes substituted with one or more substituents selected from C₁₋₁₀ alkyl, C₁₋₁₀ alkoxy and chlorine, for example toluene, xylenes and methylanisoles.

Exemplary solution deposition techniques include printing and coating techniques such spin-coating, dip-coating, flexographic printing, inkjet printing, slot-die coating and screen printing. Spin-coating and inkjet printing are particularly preferred.

Spin-coating is particularly suitable for devices wherein patterning of the light-emitting layer is unnecessary - for example for lighting applications or simple monochrome segmented displays.

The light-emitting layer may be annealed following deposition. Preferably, annealing is below the glass transition temperature of the polymer.

Inkjet printing is particularly suitable for high information content displays, in particular full colour displays. A device may be inkjet printed by providing a patterned layer over the first electrode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the photoresist may be patterned to form channels which, unlike wells, extend over a plurality of pixels and which may be closed or open at the channel ends.

Additional layers between the anode and cathode of an OLED, where present, may be formed by a solution deposition method as described herein.

### Hole injection layers

A conductive hole injection layer, which may be formed from a conductive organic or inorganic material, may be provided between the anode and the light-emitting layer or layers of an OLED to improve hole injection from the anode into the layer or layers of semiconducting polymer. Examples of doped organic hole injection materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and optionally substituted polythiophene or poly(thienothiophene). Examples of conductive inorganic materials include transition metal oxides such as VOx MoOx and RuOx as disclosed in Journal of Physics D: Applied Physics (1996), 29(11), 2750-2753.

Where a hole-transporting layer is present, a hole-injection layer may be provided between the anode and the hole-transporting layer.

### Charge transporting and charge blocking layers

A hole transporting layer may be provided between the anode and the light-emitting layer or layers. An electron transporting layer may be provided between the cathode and the light-emitting layer or layers.

An electron blocking layer may be provided between the anode and the light-emitting layer and a hole blocking layer may be provided between the cathode and the light-emitting layer. Transporting and blocking layers may be used in combination. Depending on its HOMO and LUMO levels, a single layer may both transport one of holes and electrons and block the other of holes and electrons.

A hole transporting layer preferably has a HOMO level of less than or equal to 5.5 eV, more preferably around 4.8-5.5 eV as measured by cyclic voltammetry. The HOMO level of the hole transport layer may be selected so as to be within 0.2 eV, optionally within 0.1 eV, of an adjacent layer (such as a light-emitting layer) in order to provide a small barrier to hole transport between these layers. The hole-transporting layer may be a polymer comprising repeat units of formula (I) as described above.

An electron transporting layer located between the light-emitting layers and cathode preferably has a LUMO level of around 2.5-3.5 eV as measured by cyclic voltammetry. For example, a layer of a silicon monoxide or silicon dioxide or other thin dielectric layer having thickness in the range of 0.2-2nm may be provided between the light-emitting layer nearest the cathode and the cathode. HOMO and LUMO levels may be measured using cyclic voltammetry.

A hole-transporting polymer may be a homopolymer or copolymer comprising a repeat unit of formula (VIII): 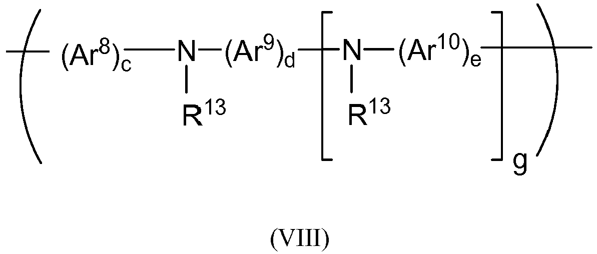
wherein Ar⁸, Ar⁹ and Ar¹⁰ in each occurrence are independently selected from substituted or unsubstituted aryl or heteroaryl, g is 0, 1 or 2, preferably 0 or 1, R¹³ independently in each occurrence is H or a substituent, preferably a substituent, and c, d and e are each independently 1, 2 or 3.
R¹³, which may be the same or different in each occurrence when g is 1 or 2, is preferably selected from the group consisting of alkyl, for example C₁₋₂₀ alkyl, Ar¹¹, a branched or linear chain of Ar¹¹ groups, or a crosslinkable unit that is bound directly to the N atom of formula (VIII) or spaced apart therefrom by a spacer group, wherein Ar¹¹ in each occurrence is independently optionally substituted aryl or heteroaryl. Exemplary spacer groups are C₁₋₂₀ alkyl, phenyl and phenyl-C₁₋₂₀ alkyl.
Any two aromatic or heteroaromatic groups selected from Ar⁸, Ar⁹, and, if present, Ar¹⁰ and Ar¹¹ directly bound to the same N atom may be linked by a direct bond or a divalent linking atom or group to another of Ar⁸, Ar⁹, Ar¹⁰ and Ar¹¹. Preferred divalent linking atoms and groups include O, S; substituted N; and substituted C.
Ar⁸ and Ar¹⁰ are preferably C₆₋₂₀ aryl, more preferably phenyl, that may be unsubstituted or substituted with one or more substituents.

In the case where g = 0, Ar⁹ is preferably C₆₋₂₀ aryl, more preferably phenyl, that may be unsubstituted or substituted with one or more substituents.

In the case where g = 1, Ar⁹ is preferably C₆₋₂₀ aryl, more preferably phenyl or a polycyclic aromatic group, for example naphthalene, perylene, anthracene or fluorene, that may be unsubstituted or substituted with one or more substituents.

R¹³ is preferably Ar¹¹ or a branched or linear chain of Ar¹¹ groups. Ar¹¹ in each occurrence is preferably phenyl that may be unsubstituted or substituted with one or more substituents.

Exemplary groups R¹³ include the following, each of which may be unsubstituted or substituted with one or more substituents, and wherein * represents a point of attachment to N: 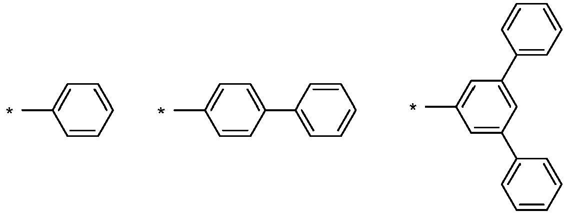
c, d and e are preferably each 1.
Ar⁸, Ar⁹, and, if present, Ar¹⁰ and Ar¹¹ are each independently unsubstituted or substituted with one or more, optionally 1, 2, 3 or 4, substituents. Exemplary substituents may be selected from:
   - substituted or unsubstituted alkyl, optionally C₁₋₂₀ alkyl, wherein one or more non-adjacent C atoms may be replaced with optionally substituted aryl or heteroaryl (preferably phenyl), O, S, C=O or -COO- and one or more H atoms may be replaced with F; and
   - a crosslinkable group attached directly to or forming part of Ar⁸, Ar⁹, Ar¹⁰ or Ar¹¹ or spaced apart therefrom by a spacer group, for example a group comprising a double bond such and a vinyl or acrylate group, or a benzocyclobutane group.

Preferred substituents of Ar⁸, Ar⁹, and, if present, Ar¹⁰ and Ar¹¹ are C₁₋₄₀ hydrocarbyl, preferably C₁₋₂₀ alkyl or a hydrocarbyl crosslinking group.

Preferred repeat units of formula (VIII) include units of formulae 1-3:

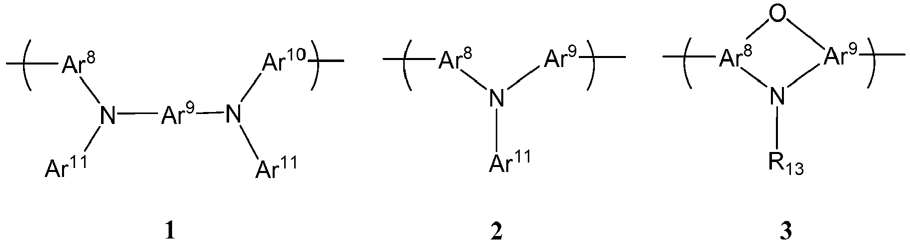

Preferably, Ar⁸, Ar¹⁰ and Ar¹¹ of repeat units of formula 1 are phenyl and Ar⁹ is phenyl or a polycyclic aromatic group.

Preferably, Ar⁸, Ar⁹ and Ar¹¹ of repeat units of formulae 2 and 3 are phenyl.

Preferably, Ar⁸ and Ar⁹ of repeat units of formula 3 are phenyl and R¹¹ is phenyl or a branched or linear chain of phenyl groups.

A polymer comprising repeat units of formula (VIII) may be a homopolymer or a copolymer containing repeat units of formula (VIII) and one or more co-repeat units.

In the case of a copolymer, repeat units of formula (VIII) may be provided in a molar amount in the range of about 1-99 mol %, optionally about 1-50 mol %.

Exemplary co-repeat units include arylene repeat units, optionally arylene units as described above.

An electron transporting layer may contain a polymer comprising a chain of optionally substituted arylene repeat units, such as a chain of fluorene repeat units.

### Cathode

The cathode is selected from materials that have a workfunction allowing injection of electrons into the light-emitting layer. Other factors influence the selection of the cathode such as the possibility of adverse interactions between the cathode and the light-emitting material. The cathode may consist of a single material such as a layer of aluminium. Alternatively, it may comprise a plurality of conductive materials, for example a plurality of conductive metals such a bilayer of a low workfunction material and a high workfunction material such as calcium and aluminium as disclosed in WO 98/10621. The cathode may comprise a layer of elemental barium, for example as disclosed in WO 98/57381, Appl. Phys. Lett. 2002, 81(4), 634 and WO 02/84759. The cathode may comprise a thin (e.g. 1-5 nm) layer of metal compound between the organic semiconducting layers and one or more conductive cathode layers, in particular an oxide or fluoride of an alkali or alkali earth metal, to assist electron injection, for example lithium fluoride, for example as disclosed in WO 00/48258; barium fluoride, for example as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

Organic optoelectronic devices tend to be sensitive to moisture and oxygen. Accordingly, the substrate preferably has good barrier properties for prevention of ingress of moisture and oxygen into the device. The substrate is commonly glass, however alternative substrates may be used, in particular where flexibility of the device is desirable. For example, the substrate may comprise one or more plastic layers, for example a substrate of alternating plastic and dielectric barrier layers or a laminate of thin glass and plastic.

The device may be encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric or an airtight container. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Measurements

Anisotropy factor α is measured using emission spectroscopy as described in M Flämmich et al, Organic Electronics 12, 2011, p.1663-1668 the contents of which are incorporated herein by reference. The average dipole orientation can be represented by a vector (x,y,z) where the z direction is normal to the plane of the thin film. This can be further parameterised as the ratio of parallel to perpendicular components p∥:p⊥ = (x+y) : z as used in Flämmich et al, or alternatively as an anisotropy factor α = z/x=z/y, as used throughout this document. In this way, isotropic orientation can be represented by (1,1,1), where p∥:p⊥ = 2 : 1 and α = 1. Additionally, an example of a anisotropic orientation can be represented as (0.3571, 0.3571, 0.2858), where p∥:p⊥ = 2.5 : 1 and α = 0.8.

Absorption anisotropy is measured by analysis of the lowest energy absorption peak using the spectroscopic ellipsometry method described in Ramsdale et al., Advanced Materials vol.14 (3), p212 (2002).

Unless stated otherwise, α values provided herein are as measured by emission spectroscopy as described above.

Square wave cyclic voltammetry as described anywhere herein may be performed by ramping a working electrode potential linearly versus time. When square wave voltammetry reaches a set potential the working electrode's potential ramp is inverted. This inversion can happen multiple times during a single experiment. The current at the working electrode is plotted versus the applied voltage to give the cyclic voltammogram trace. Apparatus to measure HOMO or LUMO energy levels by CV may comprise a cell containing a tert-butyl ammonium perchlorate/ or tertbutyl ammonium hexafluorophosphate solution in acetonitrile, a glassy carbon working electrode where the sample is coated as a film, a platinium counter electrode (donor or acceptor of electrons) and a reference glass electrode no leak Ag/AgCl. Ferrocene is added in the cell at the end of the experiment for calculation purposes.

### Measurement of the difference of potential between Ag/AgCl/ferrocene and sample/ferrocene.

Method and settings: 3mm diameter glassy carbon working electrode Ag/AgCl/no leak reference electrode Pt wire auxiliary electrode 0.1 M tetrabutylammonium hexafluorophosphate in acetonitrile LUMO = 4.8 - ferrocene (peak to peak maximum average) + onset Sample: 1 drop of 5mg/mL in toluene spun at 3000rpm LUMO (reduction) measurement:
A good reversible reduction event is typically observed for thick films measured at 200 mV/s and a switching potential of -2.5V. The reduction events should be measured and compared over 10 cycles, usually measurements are taken on the 3^{rd} cycle. The onset is taken at the intersection of lines of best fit at the steepest part of the reduction event and the baseline. HOMO and LUMO values may be measured at ambient temperature.

### Examples

### Compound Example 1

Steps 1-4 were carried out according to the following reaction scheme:

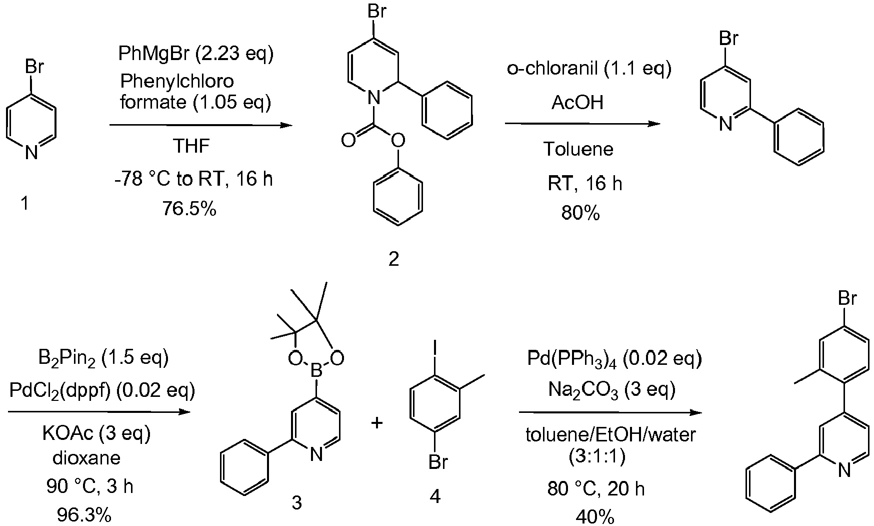

### Step 1: Synthesis of intermediate 2

| S. No | Reagent | Quantity (g) | Vol. (mL) | MW | Moles | Eq. |
|---|---|---|---|---|---|---|
| 1 | 4-Bromo pyridine.HCl | 80 | | 194.49 | 0.4113 | 1 |
| 2 | Phenyl magnesium bromide (1M in THF) | | 917 | 181.31 | 0.9172 | 2.23 |
| 3 | Phenyl chloroformate | | 54.2 | 156.57 | 0.4319 | 1.05 |
| 4 | THF | | 2000 | | | |

### Apparatus set-up:

A 5 L 3-necked round-bottomed flask, equipped with a mechanical overhead stirrer, thermo socket, nitrogen inlet and exhaust.

### Experimental procedure:

1) A suspension of 4-bromopyridine hydrochloride (80 g, 0.4113 mol) in THF (2000 mL) was taken in the flask.
2) The reaction mixture was cooled to -78 °C and 1M phenyl magnesium bromide (917 mL, 0.9172 mol) was added through additional funnel for 1 h maintaining the inner temperature between -75 °C to -70 °C.
3) The reaction mixture was maintained at -78 °C for 30 min.
4) Phenyl chloroformate (54.2 mL, 0.4319 mol) was added drop wise to the reaction mixture at -78 °C.
5) The reaction mixture was slowly warmed to RT and maintained at RT for 16 h.
6) 20 % ammonium chloride solution (1000 mL) was added to the reaction mixture.
7) The reaction mixture was extracted with ethyl acetate (2 x 1000 mL).
8) The combined organic layer was dried over Na₂SO₄ and concentrated to give 180 g of crude intermediate **2** as a pale brown viscous oil.
9) The crude was purified by a flash column chromatography over silica gel (230-400 mesh) using 2 % ethyl acetate in hexane as eluent to obtain 112 g intermediate **2** with 78.1 % HPLC purity as a pale yellow viscous oil (yield = 76.5 %).

### Step 2:

| S. No | Reagent | Quantity (g) | Vol. (mL) | MW | Moles | Eq. |
|---|---|---|---|---|---|---|
| 1 | Intermediate **2** | 112 | | 356.22 | 0.3144 | 1 |
| 2 | o-Chloranil | 85 | | 245.86 | 0.3458 | 1.1 |
| 3 | Glacial Acetic acid | | 1500 | | | |
| 4 | Toluene | | 2000 | | | |

### Apparatus set-up:

A 5 L 3-necked round-bottomed flask, equipped with a mechanical overhead stirrer, nitrogen inlet and exhaust.

### Experimental procedure:

1. The intermediate **2** (112 g, 0.3144 mol) was taken in a 5 L reaction flask with toluene (2000 mL).
2. A solution of o-chloranil (85 g, 0.3458 mol) in acetic acid (1500 mL) was added to the reaction mixture at RT during 30 minutes.
3. The reaction mixture was stirred at RT for 16 h.
4. Then the mixture was cooled to 0 °C in an ice bath.
5. 20 % Aqueous NaOH solution (5 L) was added to the reaction mixture slowly to adjust the pH range between 10 to 11.
6. The solution was extracted with methyl *t*-butyl ether (2000 mL x 3).
7. The combined organic layer was washed with water (2000 mL), brine solution (1500 mL), dried over Na₂SO₄ and concentrated to get 108 g of crude product as a pale brown viscous oil.
8. The crude product was purified in 3 batches (36 g each) by Grace column chromatography using 2 % EtOAc in hexane as eluent to get 58.8 g of product with 97.8 % HPLC purity as a pale yellow viscous oil. It contained 1.88 % of chloro derivative of product as impurity (yield = 80 %).
*¹H-NMR (400 MHz, CDCl₃):_*δ [ppm] 7.43 (dd, *J* = 1.76, 5.28 Hz, 1H), 7.47-7.53 (m, 3H), 7.93 (d, *J* = 1.72 Hz, 1H), 7.98-8.00 (m, 2H), 8.53 (d*, J* = 5.28 Hz, 1H).

### Step 3: Synthesis of intermediate 3

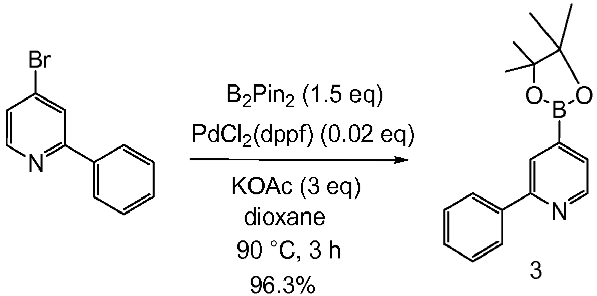

| S. No | Reagent | Quantity (g) | Vol. (mL) | MW | Moles | Eq. |
|---|---|---|---|---|---|---|
| 1 | Product from step 2 | 58.8 | | 234.1 | 0.2511 | 1 |
| 2 | Bis(pinacolato)diboron | 95.67 | | 253.94 | 0.3768 | 1.5 |
| 3 | Potassium acetate | 74 | | 98.15 | 0.7533 | 3 |
| 4 | PdCl₂(dppf).CH₂Cl₂ | 4.1 | | 816.6 | 0.005 | 0.02 |
| 5 | Dioxane | | 1090 | | | |

### Apparatus set-up:

A 3L 4-necked round-bottomed flask, equipped with a mechanical overhead stirrer, condenser, nitrogen inlet and exhaust.

### Experimental Procedure:

1. Step 2 product (58.8 g, 0.2511 mol) in dioxane (1090 mL) was taken in R. B. flask.
2. Bis(pinacolato)diboron (95.67 g, 0.3768 mol) and potassium acetate (74 g, 0.7533 mol) were added to the mixture.
3. The mixture was degassed with N₂ gas for 1 h.
4. PdCl₂(dppf) (4.1 g, 0.005 mol) was added to the mixture.
5. The reaction mixture was heated to 90 °C and maintained for 3 h.
6. The reaction mixture was cooled to room temperature and diluted with n-hexane (2 L) and stirred for 40 min and filtered through celite bed.
7. The filtrate was concentrated to obtain 108 g of intermediate **3** as crude product.
8. The crude was purified by column chromatography using neutral Al₂O₃ and 5 % ethyl acetate in hexane as eluent to afford 68 g of intermediate **3** with 95.93 % HPLC purity (yield = 96.3 %).

### Step 4

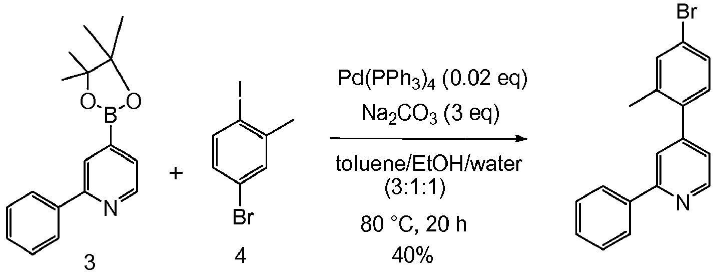

| S. No | Reagent | Quantity (g) | Vol. (mL) | MW | Moles | Eq. |
|---|---|---|---|---|---|---|
| 1 | Intermediate (**3**) | 65 | | 281.1 | 0.2313 | 1 |
| 2 | 5 - Bromo- 2- iodo toluene (**4**) | 68.67 | | 296.9 | 0.2313 | 1 |
| 3 | Sodium carbonate | 73.55 | | 106 | 0.6939 | 3 |
| 4 | Pd(PPh₃)₄ | 5.34 | | 1155.57 | 0.0046 | 0.02 |
| 5 | Toluene/EtOH/water (3:1:1) | | 1700 | | | |

### Apparatus set-up:

A 5 L 4-necked round-bottomed flask, equipped with a mechanical overhead stirrer, condenser, nitrogen inlet and exhaust.

### Experimental Procedure:

1. Intermediate **3** (65 g, 0.2313 mol) and 5-bromo-2-iodo toluene (**4**) (68.67 g, 0.2313 mol) were taken in toluene/ethanol (3:1) mixture (1360 mL).
2. The mixture was degassed with N₂ gas for 40 min.
3. Sodium carbonate (73.55 g, 0.6939 mol) was added followed by the addition of water (340 mL) and purged with N₂ gas for 30 min.
4. Pd(PPh₃)₄ (5.34 g, 0.0046 mol) was added and purged with N₂ gas for another 30 min.
5. The reaction mixture was heated to 80 °C and maintained for 20 h.
6. The reaction mixture was cooled to room temperature and water (1.5 L) was added.
7. The organic layer was separated and the aqueous layer was extracted with EtOAc (1000 mL x 3).
8. The combined organic layer was washed with water (1.5 L), brine (1.5 L), dried over Na₂SO₄ and concentrated to get 80 g of crude product as a pale brown viscous oil.
9. The crude was purified by repeated column chromatography using 230-400 silica gel and 6 % diethyl ether in hexane as eluent to afford 30 g of product as a pale orange solid with 99.78 % HPLC purity (yield = 40 %).
*¹H-NMR (400 MHz, CDCl₃):* δ [ppm] 2.31 (s, 3H), 7.14-7.19 (m, 2H), 7.43-7.52 (m, 5H), 7.67 (s, 1H), 8.03 (d, *J* = 7.60 Hz, 2H), 8.75 (d, *J* = 5.20 Hz, 1H).

### Step 5

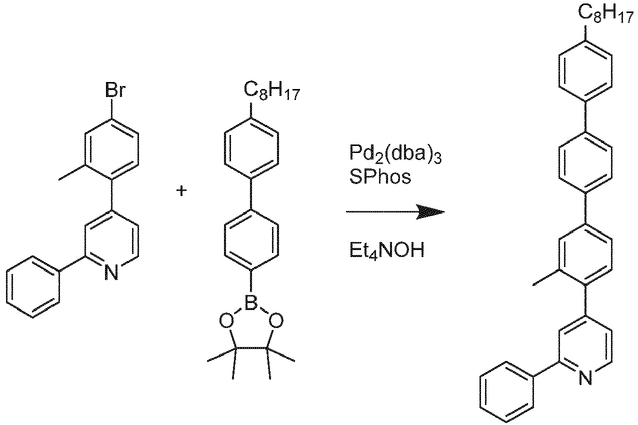

5g (15.4mmol) 2-phenyl-4-(2-methyl-4-bromophenyl)pyridine and 4'-n-octyl biphenyl-4-boronic acid pinacol ester (1.2 equivalents) were dissolved in Toluene (50mL) and bubbled with nitrogen for 1hr. Pd₂(dba)₃ (0.01 eq.) and SPhos (0.02 eq.) were added and the mixture was bubbled with nitrogen for a further 10min. Et₄NOH (20% aq solution; 4 eq.) was degassed by bubbling with nitrogen and added to the reaction and the mixture was stirred and heated at 115°C for 20hr.

After cooling to room temperature, the organic part was separated and washed with water and then the solvent removed giving a grey solid. This was purified by precipitation from dichloromethane solution into acetonitrile, followed by trituration with methanol. Finally, the material was dissolved in ethyl acetate and residual undissolved material removed by filtration. Removal of the solvent from the filtrate gave 5.7g white solid (73% yield).

### Step 6

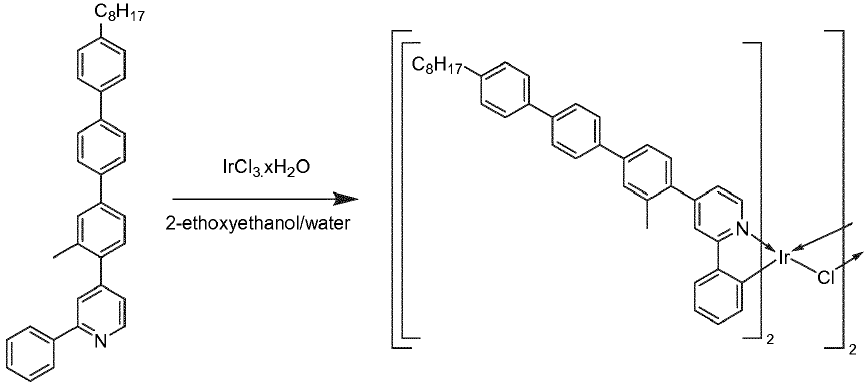

5.7g of starting material (11.18mmol) and iridium(III)chloride (0.4 equivalents) were placed in a flask and suspended in a mixture of 2-ethoxyethanol and water (76mL 3:1 mix). The mixture was bubbled with nitrogen for 1hr while stirring and then heated to 120°C for 17hr. After cooling to room temperature 200mL water was added and the mixture stirred for 30min. The yellow precipitate was collected by filtration. The product was purified by precipitation from dichloromethane into heptane, followed by precipitation from toluene into methanol. This gave 3.27g yellow solid (85% yield).

### Step 7

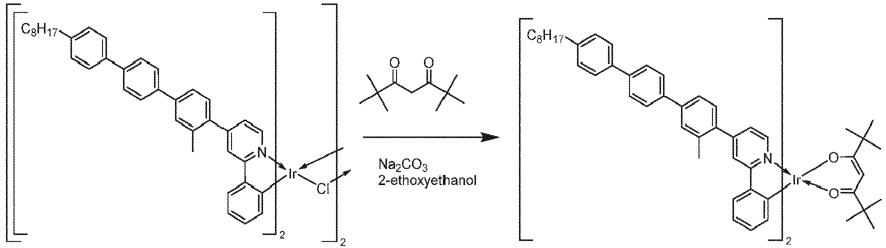

3.27g (1.31mmol) starting material, sodium carbonate (5 eq.), 2,2,6,6-tetramethyl heptan-3,5-dione (5 eq.) and 2-ethoxyothanol (65mL) were placed in a flask and bubbled with nitrogen for 1hr. The reaction was then stirred and heated at 120°C for 20hr. After cooling to room temperature, 200mL water was added to the flask then the mixture poured a beaker containing 400mL water. The resulting precipitate was collected in a Buchner funnel and washed with methanol. The resulting yellow solid was purified by recrystallisation in a mixture of dichloromethane and heptane giving 1.85g product (51% yield).

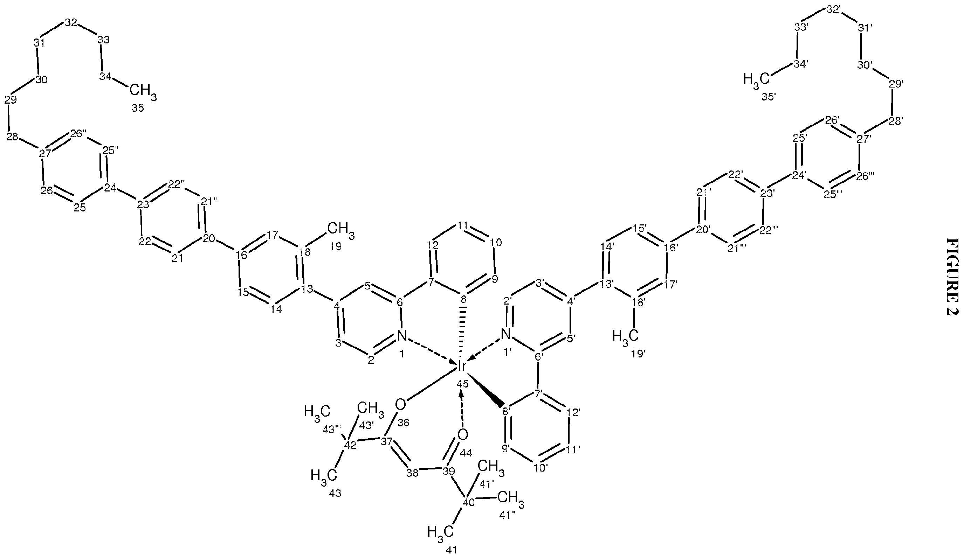

The product is illustrated in Figure 2.
¹H NMR (600MHz, CHLOROFORM-d) δ = 8.46 (2H, d, J_{2,2',3,3'} = 5.8 Hz, H-2, 2'), 7.84 (2H, s, H-5, 5'), 7.74 - 7.77 (4H, m, H-21"', 21', 21, 21"), 7.70 - 7.73 (4H, m, H-22"', 22', 22, 22"), 7.65 (2H, s, H-17, 17'), 7.63 (2H, d, J = 7.8 Hz, H-15, 15'), 7.61 (1H, s, H-9', 9), 7.60 (5H, d, J = 7.8 Hz, H-25"', 25', 25, 25"), 7.48 (2H, d, J_{14, 14',12, 12'} = 7.7 Hz, H-14, 14'), 7.26 - 7.32 (4H, m, H-26"', 26', 26, 26"), 7.11 (2H, dd, J_{3, 3',2, 2'} = 5.8 Hz, J = 1.8 Hz, H-3, 3'), 6.85 (2H, t, J_{10, 10',11, 11'} = 7.3 Hz, H-10, 10'), 6.76 (2H, t, J_{11, 11',10, 10'} = 7.4 Hz, H-11, 11'), 6.57 (2H, d, J_{12, 12',14, 14'} = 8.1 Hz, H-12, 12'), 5.55 (1H, s, H-38), 2.68 (4H, t, J_{28', 28,29', 29} = 7.8 Hz, H-28', 28), 2.49 (6H, s, H-19', 19), 1.68 (4H, quin, J_{29', 29,28', 28} = 7.6 Hz, H-29', 29), 1.30 - 1.41 (12H, m, H-32', 32, 31', 31, 30', 30), 1.26 - 1.31 (5H, m, H-33', 33), 1.25 - 1.42 (4H, m, H-34', 34), 0.95 (18H, s, H-43', 43, 43"', 41', 41, 41"), 0.87 - 0.93 (6H, m, H-35', 35)

### Compound Example 2

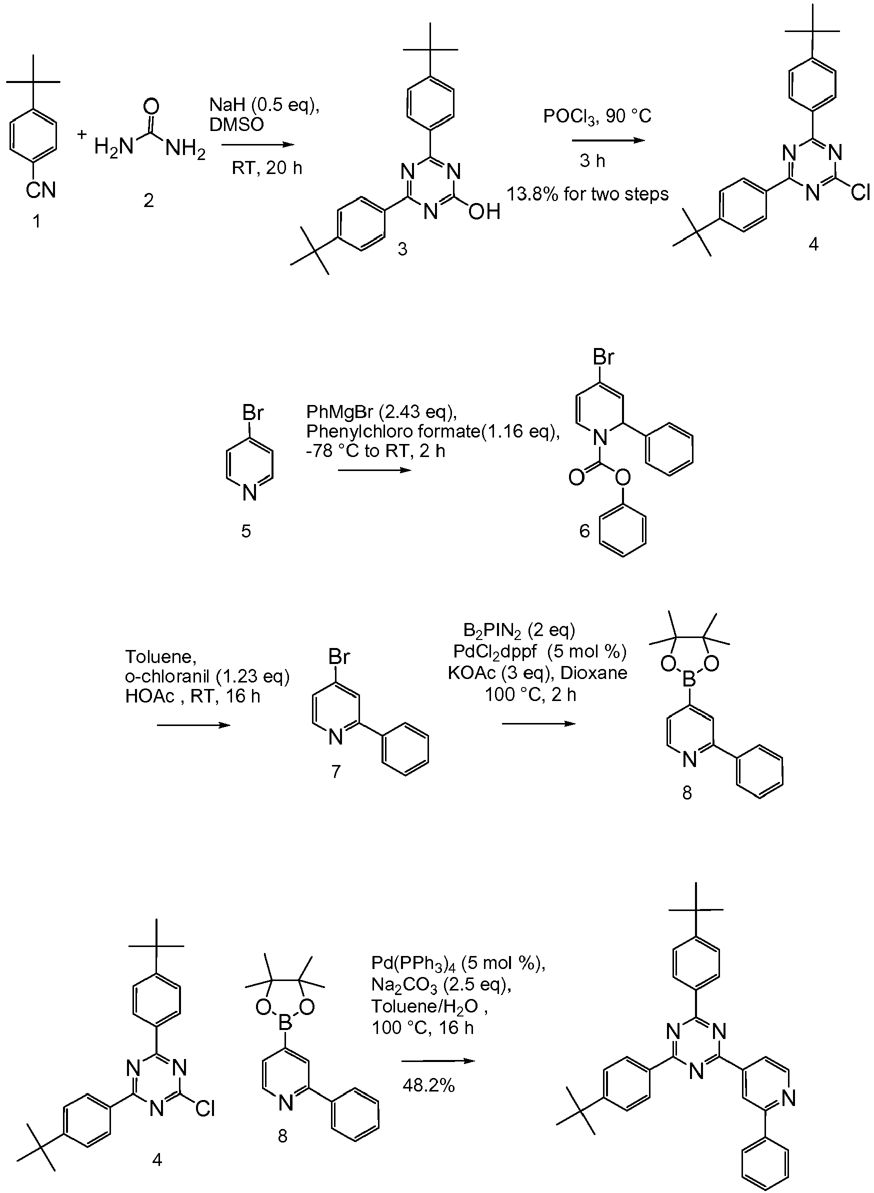

### Step 1: Synthesis of Intermediate 3

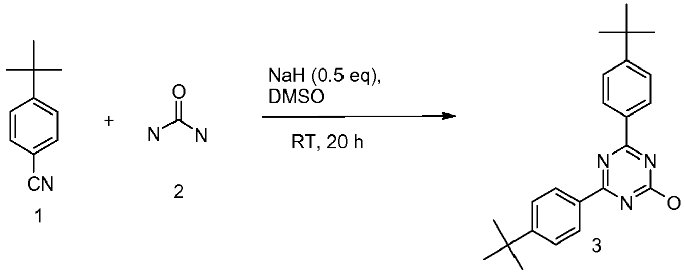

| S. No | Reagent | Quantity (g) | Vol. (mL) | MW | Moles | Eq. |
|---|---|---|---|---|---|---|
| 1 | 4-tert-Butylbenzonitrile (**1**) | 100 | | 159 | 0.6289 | 1 |
| 2 | Urea (**2**) | 9.45 | | 60 | 0.1572 | 0.25 |
| 3 | NaH (60 % in mineral oil) | 13 | | 24 | 0.3145 | 0.5 |
| 4 | DMSO | | 800 | | | |

### Apparatus set-up:

A 2L 3-necked round-bottomed flask, equipped with a mechanical overhead stirrer, condenser, nitrogen inlet and exhaust.

### Experimental procedure:

1) To a solution of 4-tert-butyl-benzonitrile (**1**) (100 g, 0.6289 mol), urea (9.45 g, 0.1572 mol) in DMSO (800 mL), sodium hydride (13 g, 0.3145 mol) was slowly added in small portions at room temperature and stirred for 16 h.
2) After completion of the reaction mixture, 5 % acetic acid in water (2 L) was added and stirred for an hour.
3) The white solid formed was filtered, washed with water (1000 mL), petroleum ether (200 mL) and dried under vacuum to afford 73 g of 4,6-bis-(4-tert-butylphenyl)-[1,3,5]triazin-2-ol (**3**) as white solid.
4) It was used as such in next step.

### Step 2: Synthesis of intermediate 4

| S. No | Reagent | Quantity (g) | Vol. (mL) | MW | Moles | Eq. |
|---|---|---|---|---|---|---|
| 1 | Intermediate (**3**) | 73 | | 361.5 | 0.2019 | 1 |
| 2 | POCl₃ | | 730 | | | |

### Apparatus set-up:

A 2L 3-necked round-bottomed flask, equipped with a mechanical overhead stirrer and condenser.

### Experimental Procedure:

1) A mixture of intermediate (**3**) (73 g, 0.2019 mol) and POCl₃ (730 mL) was heated at 90 °C for 3 h.
2) After completion of the reaction, POCl₃ was distilled off under high vacuum.
3) The residue thus obtained was carefully added to ice cold water (1000 mL) and stirred for 30 min.
4) The solid thus formed was filtered, washed with water, dried under vacuum to afford intermediate (**4**) as white solid (33 g, 13.8 % for two steps).
*¹H-NMR (400 MHz, DMSO-d₆):* δ [ppm] 8.47 (d, *J* = 7.88 Hz, 4H), 7.68 (d, *J* = 7.92 Hz, 4H), 1.36 (s, 18H).

### Step 3: Synthesis of intermediate 6

| S. No | Reagent | Quantity (g) | Vol. (mL) | MW | Moles | Eq. |
|---|---|---|---|---|---|---|
| 1 | Intermediate (**5**) | 45 | | 194.49 | 0.2314 | 1 |
| 2 | Phenyl magnesium bromide (2M in THF) | | 281 | 181.31 | 0.5622 | 2.43 |
| 3 | Phenyl chloro formate | 42.02 | | 156.57 | 0.2684 | 1.16 |
| 4 | THF | | 900 | | | |

### Apparatus set-up:

A 2L 3-necked round-bottomed flask, equipped with a mechanical overhead stirrer, condenser, nitrogen inlet and exhaust.

### Experimental procedure:

1) A solution of 4-bromo-2-pyridine hydrochloride (45 g, 0.2314 mol) in THF (700 mL) was taken in the flask.
2) The reaction mixture was cooled to -78 °C and 2M phenyl magnesium bromide (281 mL, 0.5622 mol) was added through additional funnel during 1 h maintaining -75 °C to -70 °C.
3) The reaction mass was maintained at -78 °C for an hour.
4) A solution of phenyl chloro formate (42.02 g, 0.2684 mol) in THF (200 mL) was added to the reaction mass at -78 °C.
5) The reaction mass was slowly warmed to RT and maintained at RT 16 h.
6) 20% ammonium chloride solution (400 mL) was added to the reaction mass.
7) The reaction mass was extracted with ethyl acetate (2 x 500 mL).
8) The combined organic layer was dried over Na₂SO₄ and distilled off to give 72 g of crude.
9) The crude was as such taken to next step without purification.

### Step 4: Synthesis of intermediate 7

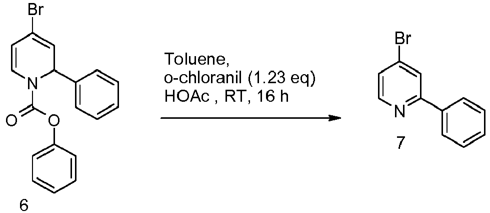

| S. No | Reagent | Quantity (g) | Vol. (mL) | MW | Moles | Eq. |
|---|---|---|---|---|---|---|
| 1 | Intermediate (**6**) (Crude) | 45 | | 194.49 | 0.2314 | 1 |
| 2 | o-Chloranil | 69.97 | | 245.86 | 0.2846 | 1.23 |
| 3 | Glacial Acetic acid | | 520 | | | |
| 4 | Toluene | | 900 | | | |

### Apparatus set-up:

A 2L 3-necked round-bottomed flask, equipped with a mechanical overhead stirrer, condenser, nitrogen inlet and exhaust.

### Experimental procedure:

1. The crude (45 g) was taken in a 2 L reaction flask with toluene (900 mL).
2. A solution of o-chloranil (69.97 g, 0.2846 mol) in acetic acid (520 mL) was added to the reaction mass at RT during 30 minutes.
3. The reaction mass was stirred at RT for 16 h.
4. Aq. 10 % NaOH solution was added to the reaction mass slowly to adjust the pH range from 10 to 11.
5. The reaction mass was filtered through celite bed.
6. Concentrated hydrochloric acid (100 mL) was added to toluene layer and stirred for 10 minutes.
7. The organic layer was separated and washed twice with 10% NaOH solution by adjusting the pH range from 10 to 11.
8. The organic layer was extracted with methyl *t*-butyl ether (200 mL x 3).
9. The combined organic layer was dried over Na₂SO₄ and distilled off to give 40 g of intermediate (**7**) with 90.7% pure by HPLC.
10. The crude was purified by column chromatography using neutral Al₂O₃ and 2 % ethyl acetate in hexane as eluent to afford 34 g of (**7**) with 97.2% HPLC purity.

### Step 5: Synthesis of intermediate 8

| S. No | Reagent | Quantity (g) | Vol. (mL) | MW | Moles | Eq. |
|---|---|---|---|---|---|---|
| 1 | Intermediate (**7**) | 34 | | 234.1 | 0.1452 | 1 |
| 2 | Bis(pinacolato)diboron | 55.32 | | 253.94 | 0.2179 | 1.5 |
| 3 | Potassium acetate | 42.77 | | 98.15 | 0.4357 | 3 |
| 4 | PdCl₂(dppf).CH₂Cl₂ | 5.93 | | 816.6 | 0.0073 | 0.05 |
| 5 | Dioxane | | 550 | | | |

### Apparatus set-up:

A 2L 4-necked round-bottomed flask, equipped with a mechanical overhead stirrer, condenser, nitrogen inlet and exhaust.

### Experimental Procedure:

1. Intermediate (**7**) (34 g, 0.1452 mol), bis(pinacolato)diboron (55.32 g, 0.2179 mol) and potassium acetate (42.77 g, 0.4357 mol) were taken in dioxane (550 mL).
2. The above mixture was degassed with N₂ gas for 30 minutes.
3. PdCl₂(dppf) (5.93 g, 0.0073 mol) was added.
4. The reaction mixture was heated to 100 °C and maintained for 2 h.
5. The reaction mixture was cooled to room temperature and filtered through celite bed.
6. The filtrate was concentrated to obtain 58 g of **8** as crude product.
7. The crude was purified by column chromatography using neutral Al₂O₃ and 2 % ethyl acetate in hexane as eluent to afford 45 g of (**8**) with 96.4% HPLC purity.

### Step 6

| S. No | Reagent | Quantity (g) | Vol. (mL) | MW | Moles | Eq. |
|---|---|---|---|---|---|---|
| 1 | Intermediate (**4**) | 49 | | 379.9 | 0.1290 | 1 |
| 2 | Intermediate (**8**) | 39.88 | | 281.1 | 0.1419 | 1.1 |
| 3 | Pd(PPh₃)₄ | 7.45 | | 1155.6 | 0.0064 | 0.05 |
| 4 | Sodium carbonate | 34.18 | | 105.99 | 0.3225 | 2.5 |
| 5 | Toluene | | 800 | | | |
| 6 | Distilled water | | 200 | | | |

### Apparatus set-up:

A 2 L 3-necked round-bottomed flask equipped with a mechanical stirrer, nitrogen inlet and exhaust.

### Experimental Procedure:

1) Intermediate **4** (49 g, 0.1290 mol), intermediate **8** (39.88 g, 0.1419 mol) and sodium carbonate (34.18 g, 0.3225 mol), toluene (800 mL) and distilled water (200 mL) under nitrogen atmosphere.
2) The above reaction mixture was degassed and purged with argon for 30 minutes.
3) Pd(PPh₃)₄ (7.45 g, 0.0064 mol) was added and the reaction mass was heated at 100 °C for 16 h.
4) The dark brown crude mass was cooled to room temperature, filtered through celite bed and washed with ethyl acetate (500 mL).
5) Water (500 mL) was added to the filtrate.
6) The organic phase was separated, washed with brine (500 mL), dried over sodium sulphate, filtered and concentrated to yield ∼ 61 g of dark brown oil as crude product.
7) Acetonitrile (400 mL) was added to the crude and stirred for 2 h at RT.
8) The solid was filtered off and washed with acetonitrile (2 x 100 mL).
9) The crude was purified by column chromatography using silica gel (230-400 mesh) and 5 % ethyl acetate in hexane as eluent to afford 38 g of product with 98.9% HPLC purity.
10) The compound (38 g) was dissolved in a mixture of acetonitrile (560 mL) and ethyl acetate (240 mL) and cooled to RT.
11) The solid was filtered off and dried under vacuum to yield 31 g (yield: 48.2 %) with 99.67% HPLC purity.
*¹H-NMR (400 MHz, CDCl₃):* δ [ppm] 9.03 (s, 1H), 8.97 (d, *J* = 5.04 Hz, 1H), 8.72 (d, *J* = 8.36 Hz, 4H), 8.53 (d, *J* = 5.04 Hz, 1H), 8.20 (d, *J* = 7.16 Hz, 2H), 7.65 (d, *J* = 8.36 Hz, 4H), 7.57-7.61 (m, 2H), 7.52-7.53 (m, 1H), 1.44 (s, 18H).
*¹³C-NMR (100 MHz, CDCl₃):* δ [ppm] 172.00, 170.06, 158.39, 156.56, 150.42, 144.87, 139.20, 133.11, 129.26, 128.93, 28.86, 127.16, 125.76, 120.80, 119.23, 35.16, 31.22

### Step 7

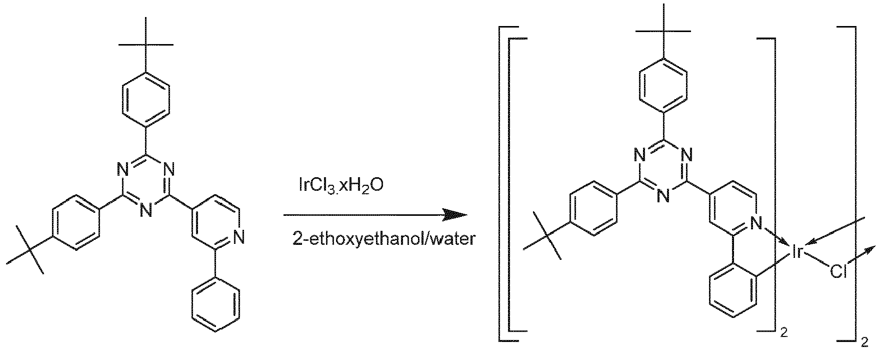

6.45g Iridium(III) chloride hydrate (18.2mmol) and starting material (2.2 equivalents) were placed in a flask and suspended in a 3:1 mixture of 2-ethoxyethanol/water (360mL). The mixture was degassed for 1h before stirring at 125°C for 14hr. The vessel was protected from light for the duration of the reaction. After cooling to room temperature, 200mL water was added and the mixture stirred for 15min. The precipitated solid was collected by filtration and washed with 200mL water followed by 300mL ethanol and 500mL methanol. Product used without further purification - 18.98g (85% yield).

### Step 8

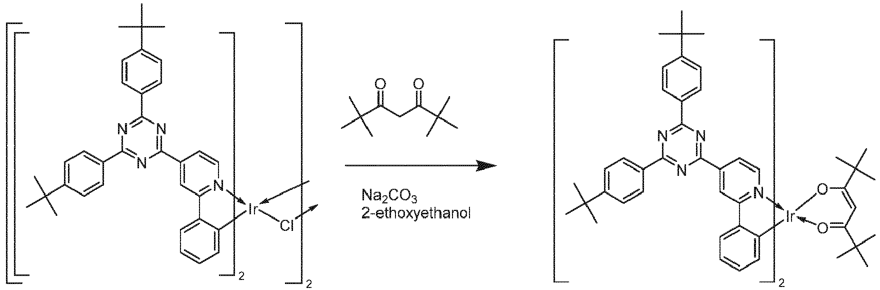

3g (1.23mmol) of starting material and sodium carbonate (10.0 eq) were placed in a flask and suspended in 80mL 2-ethoxyethanol. In a dropping funnel, 2,2,6,6-tetramethylheptan-3,5-dione (4.0 eq.) was dissolved in 20mL 2-ethoxyethanol. Both solutions were bubbled with nitrogen for 40min. The reaction flask was stirred and heated to 60°C then the solution from the dropping funnel was added. The temperature was increased to 130°C and the reaction stirred for 18hr. After cooling to room temperature, 100mL water was added to the flask and stirred for 20min. The precipitated product was collected by filtration and washed with water. The resulting deep red solid was purified by column chromatography followed by recrystallisation from toluene/acetonitrile.

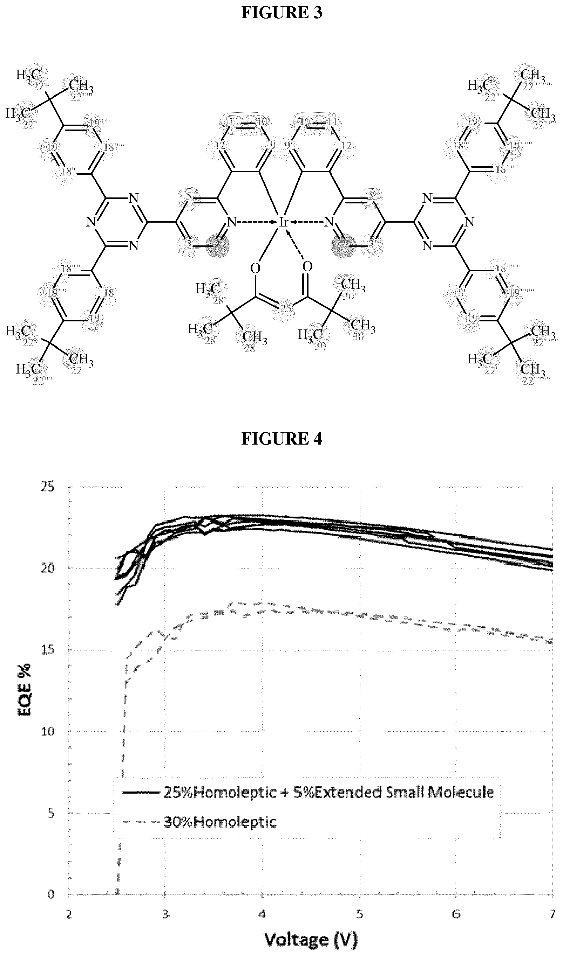

The product is illustrated in Figure 3.
¹H NMR (600MHz, CHLOROFORM-d) δ = 9.17 (2H, s, H-5, 5'), 8.75 (8H, d, J = 8.5 Hz, H-18", 18""', 18"""', 18', 18, 18"", 18"', 18"""), 8.71 (2H, d, J = 5.9 Hz, H-2, 2'), 8.37 (2H, dd, J = 5.9 Hz, J = 1.5 Hz, H-3, 3'), 7.85 - 7.90 (2H, m, J = 7.6 Hz, H-12, 12'), 7.66 (8H, d, J = 8.5 Hz, H-19", 19""', 19"""', 19', 19, 19"", 19"', 19"""), 6.92 - 6.97 (1H, m, M02), 6.94 (2H, t, J = 7.3 Hz, H-11, 11'), 6.76 (2H, t, J = 7.3 Hz, H-10, 10'), 6.46 - 6.50 (2H, m, J = 7.6 Hz, H-9, 9'), 5.58 (1H, s, H-25), 1.44 (37H, s, H-22", 22""', 22*, 22', 22"""', 22"""", 22*', 22, 22"", 22"', 22""", 22""""'), 0.98 (15H, s, H-28", 28, 28', 30, 30", 30')

### Composition Example 1

A film of a composition of Compound Example 2 (5 wt %) and Host Polymer 1 (95 wt %) was formed by spin-coating and the anisotropy factor α was measured by emission spectroscopy as described herein.

Host Polymer 1 is a polymer formed by Suzuki polymerisation as described in WO00/53656 and comprises repeat units of formulae VIIa (50 mol %), XI (40 mol %) and X (10 mol %) as described above.

The α value was 0.79.

### Comparative Composition 1

A film was prepared as described for Composition Example 1 except that Comparative Compound 1, illustrated below, was used in place of Compound Example 2.

The α value was 1.09.

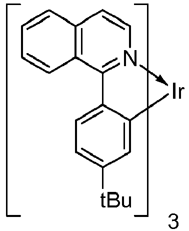

### Comparative Compound 1

### Composition Example 2

A film of a composition of Compound Example 1 (5 wt %) and Host Polymer 2 (95 wt %) was formed by spin-coating and the anisotropy factor α was measured by emission spectroscopy as described herein.

Host Polymer 2 is a polymer formed by Suzuki polymerisation as described in WO00/53656 and comprises repeat units of formulae VIIa (50 mol %) and XI (50 mol %) as described above.

The α value was 0.33.

### Comparative Device 1

An organic light-emitting device having the following structure was prepared:

ITO / HIL / HTL / LEL / Cathode

wherein ITO is an indium-tin oxide anode; HIL is a hole-injecting layer comprising a hole-injecting material, HTL is a hole-transporting layer and LEL is a light-emitting layer.

A substrate carrying ITO (45 nm) was cleaned using UV / Ozone. A hole injection layer was formed to a thickness of about 65 nm by spin-coating a formulation of a hole-injection material. A hole transporting layer was formed to a thickness of about 22 nm by spin-coating a hole-transporting polymer comprising phenylene repeat units of formula (VII), amine repeat units of formula (VIII-1) and crosslinkable repeat units of formula (IXa) and crosslinking the polymer by heating. The light-emitting layer was formed to a thickness of about 83 nm by spin-coating a mixture of Host Polymer 3 : Comparative Compound 2 (70 wt % : 30 wt %). A cathode was formed on the light-emitting layer of a first layer of sodium fluoride of about 2 nm thickness, a layer of aluminium of about 100 nm thickness and a layer of silver of about 100 nm thickness.

Host Polymer 3 is a block polymer formed by Suzuki polymerisation as described in WO 00/53656 of a first block formed by polymerisation of the monomers of Set 1, and a second block formed by polymerisation of the monomers of Set 2.

### Set 1:

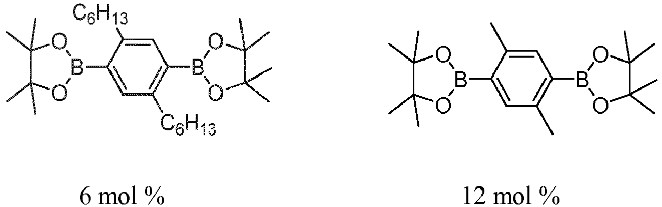

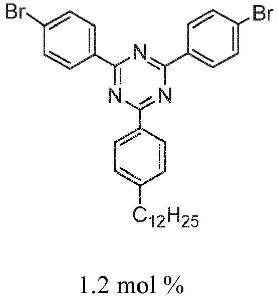

### Set 2:

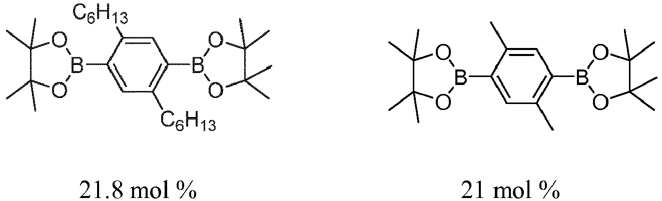

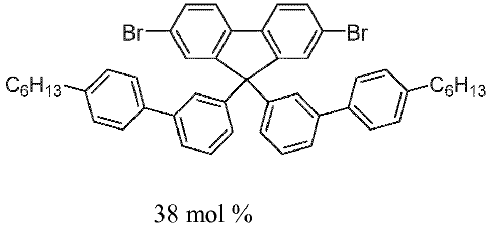

Comparative Compound 2 has the following structure:

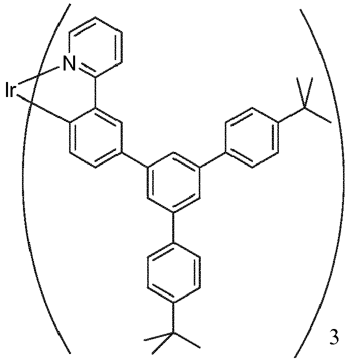

### Device Example 1

A device was prepared as described for Comparative Device 1 except that 5 wt % of Comparative Compound 1 was replaced with 5 wt% of Compound Example 1.

Efficiency of Device Example 1 was about 97 cd/A whereas efficiency of Comparative Device 1 was about 76 cd/A.

With reference to Figure 4, external quantum efficiency of Device Example 1 (solid line) is considerably higher than that of Comparative Device 1 (dotted line).

Although the present invention has been described in terms of specific exemplary embodiments, it will be appreciated that various modifications, alterations and/or combinations of features disclosed herein will be apparent to those skilled in the art without departing from the scope of the invention as set forth in the following claims.

## Claims

1. A light-emitting phosphorescent complex configured for use in an organic light-emitting device, comprising:
a second or third row transition metal atom;
a light-emitting ligand L coupled with/bound to the transition metal atom to form a transition dipole moment and substituted with a group X, wherein:
the group X has a formula - (Ar)ₚ;
Ar is independently an aryl or heteroaryl group that may be unsubstituted or substituted with one or more substituents and p is at least 2; and
an a:b aspect ratio of the light-emitting phosphorescent complex is at least 3:1, where a is a dimension of the light-emitting phosphorescent complex in a direction parallel to the transition dipole moment and b is a dimension of the light-emitting phosphorescent complex in any direction perpendicular to the transition dipole moment; and
the light-emitting phosphorescent complex is configured to provide that the transition dipole moment aligns parallel to a plane of a surface onto which the light-emitting phosphorescent complex is deposited.

2. The light-emitting phosphorescent complex according to claim 1, wherein the group X is aligned substantially parallel with the transition dipole moment.

3. The light-emitting phosphorescent complex according to claim 1 or claim 2, wherein a ligand-X bond between the light-emitting ligand and the group X is substantially parallel with the dimension a.

4. The light-emitting phosphorescent complex according to any one of claims 1 through 3, wherein an angle between the transition dipole moment and a ligand-X bond between the light-emitting ligand and the group X is less than 20 degrees, less than 15 degrees, less than 10 degrees, less than 5 degrees or about 0 degrees.

5. The light-emitting phosphorescent complex according to any one of claims 1 through 4, wherein the light-emitting phosphorescent complex comprises a rod like backbone extending substantially parallel to the transition dipole moment, the dimension (a) and the ligand-X bond between the light-emitting ligand and the group X.

6. The light-emitting phosphorescent complex according to any one of claims 1 through 5, wherein the a:b aspect ratio of the light-emitting phosphorescent complex is at least 4:1 or at least 5:1.

7. The light-emitting phosphorescent complex according to any one of claims 1 through 6, wherein the light-emitting ligand L comprises a bidentate ligand and the light-emitting phosphorescent complex comprises an auxiliary ligand.

8. The light-emitting phosphorescent complex according to any one of claims 1 through 7, wherein the second or third row transition metal atom comprises a platinum atom or an iridium atom.

9. A composition configured for use in a light-emitting layer of an organic light-emitting device, comprising:
a host material; and
a light-emitting phosphorescent complex, comprising:
a second or third row transition metal atom;
a light-emitting ligand L coupled with/bound to the transition metal atom to form a transition dipole moment and substituted with at least one group X, wherein:
the group X has a formula -(Ar)ₚ;
Ar is independently an aryl or heteroaryl group that may be unsubstituted or substituted with one or more substituents and p is at least 2; and
an a:b aspect ratio of the light-emitting phosphorescent complex is at least 3:1, where (a) is a dimension of the light-emitting phosphorescent complex in a direction parallel to the transition dipole moment and (b) is a dimension of the light-emitting phosphorescent complex in any direction perpendicular to the transition dipole moment; and wherein:
the composition is configured to provide that the transition dipole moment of the light-emitting phosphorescent complex is aligned parallel to a plane of a surface onto which the composition is deposited.

10. A composition according to claim 9, wherein the host material comprises a small molecule, a dendrimeric material or a polymeric material and the light-emitting phosphorescent complex is admixed with the host material and/or covalently bound with the host material.

11. A composition according to any one of claims 9 or 10, wherein the composition or a light-emitting layer formed of the composition has an anisotropy factor (α) of less than 0.85, less than 0.5 or less than 0.4.

12. An organic light-emitting device, comprising:
a cathode;
an anode having a surface extending parallel to the cathode; and
a light-emitting layer disposed between the anode and cathode, wherein:
the light-emitting layer comprises a plurality of molecules of a light-emitting phosphorescent complex and each of the plurality of molecules of the light-emitting phosphorescent complex comprises:
a metal atom of a second or third row transition metal;
a light-emitting ligand L coupled with the metal atom to form a transition dipole moment and substituted with at least one group X, wherein:
the group X comprises an aryl of formula -(Ar)p, where Ar is independently an aryl or heteroaryl group that may be unsubstituted or substituted with one or more substituents and p is at least 2;
an a:b aspect ratio of the light-emitting phosphorescent complex is at least 3:1, where (a) is a dimension of the organic light emitting complex in a direction parallel to the transition dipole moment and (b) is a dimension of the organic light-emitting complex in any direction perpendicular to the transition dipole moment; and wherein:
the transition dipole moments of the plurality of molecules of the light-emitting phosphorescent complex are arranged parallel to a plane of the surface of the anode.

13. The organic light-emitting device according to claim 12, wherein the light-emitting layer further comprises:
a host material, and wherein the plurality of molecules of the light-emitting phosphorescent complex are admixed with the host material and/or covalently bound with the host material.

14. The organic light-emitting device according to claim 12 or claim 13, wherein an anisotropy factor (α) of the light emitting layer is less than about 0.85, less than about 0.5 or less than about 0.4.

15. A method of forming an organic light-emitting device, comprising:
depositing a solvent mixture onto a surface of the organic light-emitting device to form a light-emitting layer, wherein:
the light-emitting layer is disposed between an anode and a cathode of the organic light-emitting device;
the solvent mixture comprises a solvent, a host material and a plurality of molecules of a light-emitting phosphorescent complex, wherein each of the plurality of molecules of the light-emitting phosphorescent complex comprises:
a metal atom, wherein the metal atom comprises an atom of a second or third row transition metal; and
a light emitting-ligand coupled with the metal atom to form a transition dipole moment and substituted with a group X; and wherein:
the group X comprises an aryl of formula -(Ar)p, where Ar is independently an aryl or heteroaryl group that may be unsubstituted or substituted with one or more substituents, and p is at least 2; and
an a:b aspect ratio of the phosphorescent organic light emitting complex is at least 3:1, where (a) is a dimension of the organic light emitting complex in a direction parallel to the transition dipole moment and (b) is a dimension of the organic light emitting complex in any direction perpendicular to the transition dipole moment; and
the transition dipole moments of the plurality of molecules of the light-emitting phosphorescent complex are aligned parallel to the surface.

16. The method according to claim 15, wherein depositing the solvent mixture onto the surface, comprises one of ink jet printing the solvent mixture onto the surface or coating the solvent mixture onto the surface.
